# EUROPEAN PATENT APPLICATION

(11) **EP 4 803 675 A1**
(43) Date of publication of application: **09.09.2026**
(21) Application number: 24885656.9
(22) Date of filing: 28.10.2024
(51) Int. Cl.: C30B 29/36, C30B 23/02

(54) **DESIGN ASSISTANCE SYSTEM, DESIGN ASSISTANCE METHOD, AND DESIGN ASSISTANCE PROGRAM**

(30) Priority: 30.10.2023 JP 2023185442
(71) Applicant: Resonac Corporation, Tokyo 105-7325 (JP)
(72) Inventor: KINDAICHI, Rimpei, Tokyo 105-7325 (JP); SUDOH, Nobutoshi, Tokyo 105-7325 (JP); OKANO, Yu, Tokyo 105-7325 (JP); HAYASHIDA, Kenji, Tokyo 105-7325 (JP)
(74) Representative: Strehl & Partner mbB
(86) International application number: PCT/JP2024/038325
(87) International publication number: WO 2025/094883

(57) **Abstract**

A design assistance system for assisting in designing growth conditions applied to a process for growing an SiC single crystal using a sublimation method includes a first storage unit configured to store a first trained model that has been trained using first training data including growth conditions at each time point input into a simulation apparatus that reproduces the process, and first-item data indicating a state inside a furnace at each time point, the first-item data being simulated based on the growth conditions input at each time point, a prediction unit configured to predict first-item data indicating a state inside the furnace at each time point by inputting growth conditions for prediction at each time point into the first trained model, and a display unit configured to display the predicted first-item data.

## Description

### BACKGROUND OF THE INVENTION

The disclosures herein relate to design assistance systems, design assistance methods, and design assistance programs.

### BACKGROUND ART

As a method for growing SiC single crystals, a sublimation method is known. In order to grow SiC single crystals in a desired growth process by the sublimation method, it is necessary to appropriately change various growth conditions such as heater output and heater position with time.

For this reason, a simulation of the growth process of SiC single crystals has been conventionally carried out in designing the growth conditions.

### CITATION LIST

### PATENT LITERATURE

PTL 1: Japanese Laid-Open Patent Publication no. 2018-169818

### NON-PATENT LITERATURE

NPL 1: Shunta Harada et al., "Design of High-quality SiC Solution Growth Condition Assisted by Machine Learning", Materia Japan vol. 59, no. 3 (2020), pp. 145 to 152.

### SUMMARY OF THE INVENTION

### PROBLEM TO BE SOLVED BY THE INVENTION

However, simulating the growth process of SiC single crystal requires a huge calculation cost, and it has been difficult to smoothly design the growth conditions.

The present disclosure assists in designing growth conditions in a process for growing an SiC single crystal using a sublimation method.

### MEANS FOR SOLVING PROBLEM

Aspect 1 of the present disclosure is design assistance system for assisting in designing growth conditions applied to a process for growing an SiC single crystal using a sublimation method, including:
a first storage unit configured to store a first trained model that has been trained using first training data including:
   growth conditions at each time point input into a simulation apparatus that reproduces the process; and
   first-item data indicating a state inside a furnace at each time point, the first-item data being simulated based on the growth conditions input at each time point;
a prediction unit configured to predict first-item data indicating a state inside the furnace at each time point by inputting growth conditions for prediction at each time point into the first trained model; and
a display unit configured to display the predicted first-item data.

Aspect 2 of the present disclosure is the design assistance system according to aspect 1, wherein:
the first storage unit is configured to store the first trained model that has been trained using the first training data including:
   the growth conditions at each time point and coordinates of each position inside the furnace; and
   the first-item data indicating the state inside the furnace at each time point at each position inside the furnace, the first-item data being simulated based on the growth conditions at each time point;
the prediction unit is configured to predict first-item data indicating a state inside the furnace at each time point at each position inside the furnace by inputting growth conditions for prediction at each time point and coordinates of each position inside the furnace into the first trained model; and
the display unit is configured to display the predicted first-item data.

Aspect 3 of the present disclosure is the design assistance system according to aspect 2, wherein the first trained model is generated by updating a parameter of a first model so as to minimize a calculation result at a loss function capable of calculating a difference between:
first-item data output from the first model when the growth conditions at each time point and coordinates of each position inside the furnace included in the first training data are input into the first model; and
first-item data corresponding to the growth conditions at each time point and coordinates of each position inside the furnace included in the first training data.

Aspect 4 of the present disclosure is the design assistance system according to aspect 2, wherein the first trained model is generated by updating a parameter of a first model so as to minimize a calculation result at a loss function capable of calculating a difference between:
data obtained by applying an image processing filter to first-item data output from the first model when the growth conditions at each time point and coordinates of each position inside the furnace included in the first training data are input into the first model; and
data obtained by applying the image processing filter to first-item data corresponding to the growth conditions at each time point and coordinates of each position inside the furnace included in the first training data.

Aspect 5 of the present disclosure is the design assistance system according to aspect 2, wherein the first trained model is generated by updating a parameter of a first model so as to minimize a calculation result at a loss function capable of performing weighted addition of:
a difference between:
   first-item data output from the first model; and
   first-item data corresponding to the growth conditions at each time point and coordinates of each position inside the furnace included in the first training data; and
a difference between:
   data obtained by applying an image processing filter to the first-item data output from the first model; and
   data obtained by applying the image processing filter to the first-item data corresponding to the growth conditions at each time point and coordinates of each position inside the furnace included in the first training data.

Aspect 6 of the present disclosure is the design assistance system according to any one of aspects 2 to 5, wherein the first-item data indicating the state inside the furnace at each time point at each position inside the furnace includes any one of:
temperature at each time point at each position inside the furnace;
a gas concentration at each time point at each position inside the furnace;
a gas flow rate at each time point at each position inside the furnace; and
raw material porosity at each time point at each position inside the furnace.

Aspect 7 of the present disclosure is the design assistance system according to aspect 1, wherein the first-item data indicating the state inside the furnace at each time point includes any one of:
a raw material sublimation amount at each time point; and
SiC single crystal increase in an amount at each time point.

Aspect 8 of the present disclosure is the design assistance system according to any one of aspects 2 to 6, including a second storage unit configured to store:
the first-item data indicating the state inside the furnace at each time point at each position inside the furnace, the first-item data being simulated based on the growth conditions input into the simulation apparatus that reproduces the process at each time point; and
a second trained model that has been trained using second training data including second-item data corresponding to the first-item data, wherein:
   the prediction unit is configured to:
   input the first-item data indicating the state inside the furnace at each time point at each position inside the furnace, predicted by inputting the growth conditions at each time point and coordinates of each position inside the furnace into the first trained model, into the second trained model; and
   predict the second-item data indicating the state inside the furnace at each time point at each position inside the furnace; and
   the display unit is configured to display the predicted second-item data.

Aspect 9 of the present disclosure is the design assistance system according to aspect 8, wherein the second trained model is generated by updating a parameter of a second model so as to minimize a calculation result at a loss function capable of calculating a difference between:
second-item data output from the second model when the first-item data included in the second training data is input into the second model; and
second-item data corresponding to the input first-item data included in the second training data.

Aspect 10 of the present disclosure is the design assistance system according to aspect 9, wherein a combination of the first-item data and the second-item data included in the second training data includes any one of:
a combination of temperature at each time point at each position inside the furnace and raw material porosity at each time point at each position inside the furnace; and
a combination of raw material sublimation amount at each time point at each position inside the furnace and SiC single crystal increase in an amount at each time point at each position inside the furnace.

Aspect 11 of the present disclosure is the design assistance system according to aspect 10, wherein the raw material sublimation amount at each time point is calculated based on the raw material porosity at each time point at each position inside the furnace.

Aspect 12 of the present disclosure is the design assistance system according to aspect 1 or 2, further including a search unit configured to search for the growth conditions for prediction at each time for predicting the first-item data after change, when a change in a part of the first-item data predicted by the prediction unit is received, wherein the display unit is configured to display the growth conditions for prediction at each time that has been searched for.

Aspect 13 of the present disclosure is the design assistance system according to aspect 8, further including a search unit configured to search for the growth conditions for prediction at each time for predicting the second-item data after change, when a change in a part of the second-item data predicted by the prediction unit is received, wherein the display unit is configured to display the growth conditions for prediction at each time that has been searched for.

Aspect 14 of the present disclosure is the design assistance system according to aspect 1 or 2, wherein the first trained model is a recurrent neural network.

Aspect 15 of the present disclosure is the design assistance system according to aspect 8, wherein the second trained model is a recurrent neural network.

Aspect 16 of the present disclosure is the design assistance system according to aspect 14 or 15, wherein the recurrent neural network is any one of RNN, LSTM, GRU, Seq2Seq, Bidirectional RNN, Seq2Seq with attention mechanism, and Transformer.

Aspect 17 of the present disclosure is a design assistance method wherein a computer of a design assistance system for assisting in designing growth conditions applied to a process for growing an SiC single crystal using a sublimation method is configured to execute:
reading, from a first storage unit, a first trained model that has been trained using first training data including:
   growth conditions at each time point input into a simulation apparatus that reproduces the process; and
   first-item data indicating a state inside a furnace at each time point, the first-item data being simulated based on the growth conditions input at each time point;
predicting first-item data indicating a state inside the furnace at each time point by inputting growth conditions for prediction at each time point into the first trained model; and
displaying the predicted first-item data.

Aspect 18 of the present disclosure is a design assistance program for causing a computer of a design assistance system for assisting in designing growth conditions applied to a process for growing an SiC single crystal using a sublimation method to execute:
reading, from a first storage unit, a first trained model that has been trained using first training data including:
   growth conditions at each time point input into a simulation apparatus that reproduces the process; and
   first-item data indicating a state inside a furnace at each time point, the first-item data being simulated based on the growth conditions input at each time point;
predicting first-item data indicating a state inside the furnace at each time point by inputting growth conditions for prediction at each time point into the first trained model; and
displaying the predicted first-item data.

### EFFECT OF THE INVENTION

According to the present disclosure, it is possible to assist in designing growth conditions in a process for growing an SiC single crystal using a sublimation method.

### BRIEF DESCRIPTION OF THE DRAWINGS

[FIG. 1] FIG. 1 is a first drawing illustrating an example of a system configuration of a design assistance system.
[FIG. 2A] FIG. 2A is a drawing illustrating an outline of a growth apparatus.
[FIG. 2B] FIG. 2B is a drawing illustrating growth conditions and a state inside a furnace in the growth apparatus.
[FIG. 2C] FIG. 2C is a drawing illustrating a relationship between changes with time in the growth conditions and changes with time in information indicating the state inside the furnace in the growth apparatus.
[FIG. 2D] FIG. 2D is a drawing illustrating a specific example of a relationship between changes with time in the growth conditions and the changes with time in the information indicating the state inside the furnace in the growth apparatus.
[FIG. 3] FIG. 3 is a drawing illustrating an example of a hardware configuration of a simulation apparatus, a training apparatus, and a design assistance apparatus.
[FIG. 4] FIG. 4 is a drawing illustrating a specific example of processing of the simulation apparatus.
[FIG. 5] FIG. 5 is a drawing illustrating an example of a functional configuration of the training apparatus.
[FIG. 6] FIG. 6 is a first drawing illustrating examples of training data.
[FIG. 7] FIG. 7 is a second drawing illustrating examples of the training data.
[FIG. 8] FIG. 8 is a third drawing illustrating examples of the training data.
[FIG. 9] FIG. 9 is a fourth drawing illustrating examples of the training data.
[FIG. 10] FIG. 10 is a flowchart illustrating a flow of training data generation processing and training processing.
[FIG. 11] FIG. 11 is a first drawing illustrating a specific example of the training processing by a training unit.
[FIG. 12] FIG. 12 is a second drawing illustrating a specific example of the training processing by the training unit.
[FIG. 13] FIG. 13 is a third drawing illustrating a specific example of the training processing by the training unit.
[FIG. 14] FIG. 14 is a fourth drawing illustrating a specific example of the training processing by the training unit.
[FIG. 15] FIG. 15 is a first drawing illustrating an example of a functional configuration of a design assistance apparatus.
[FIG. 16] FIG. 16 is a drawing illustrating variation of prediction processing by a prediction unit.
[FIG. 17] FIG. 17 is a first drawing illustrating a specific example of the prediction processing by the prediction unit.
[FIG. 18] FIG. 18 is a second drawing illustrating a specific example of the prediction processing by the prediction unit.
[FIG. 19] FIG. 19 is a third drawing illustrating a specific example of the prediction processing by the prediction unit.
[FIG. 20] FIG. 20 is a first drawing illustrating an example of a design assistance screen.
[FIG. 21] FIG. 21 is a second drawing illustrating the example of the design assistance screen.
[FIG. 22] FIG. 22 is a third drawing illustrating the example of the design assistance screen.
[FIG. 23] FIG. 23 is a fourth drawing illustrating the example of the design assistance screen.
[FIG. 24] FIG. 24 is a first flowchart illustrating a flow of design assistance processing.
[FIG. 25] FIG. 25 is a second drawing illustrating an example of a functional configuration of a design assistance apparatus.
[FIG. 26] FIG. 26 is a fourth drawing illustrating the example of the design assistance screen.
[FIG. 27] FIG. 27 is a second flowchart illustrating the flow of the design assistance processing.
[FIG. 28] FIG. 28 is a second drawing illustrating an example of the system configuration of the design assistance system.

### DESCRIPTION OF THE PREFERRED EMBODIMENTS

In the following, embodiments of the present invention will be described with reference to the accompanying drawings. In the drawings, the same or corresponding constituent elements are denoted with the same reference numerals, and redundant description thereabout may be omitted.

### [FIRST EMBODIMENT]

### <SYSTEM CONFIGURATION OF DESIGN ASSISTANCE SYSTEM>

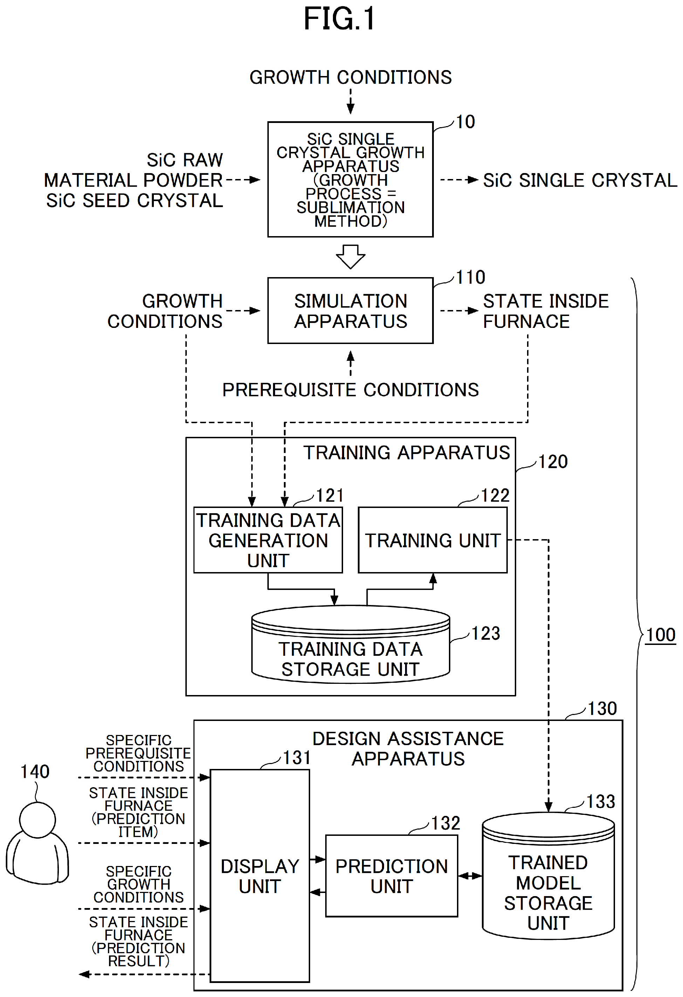

First, a system configuration of a design assistance system according to a first embodiment will be described. FIG. 1 is a first drawing illustrating an example of a system configuration of a design assistance system.

As shown in FIG. 1, the design assistance system 100 according to the first embodiment includes a simulation apparatus 110, a training apparatus 120, and a design assistance apparatus 130.

Prerequisite conditions for reproducing the target growth apparatus 10 are set in the simulation apparatus 110. In the first embodiment, the target growth apparatus 10 is a device for growing an SiC single crystal by a sublimation method.

By setting the prerequisite conditions, changes with time for various growth conditions are input to the simulation apparatus 110 in which the growth apparatus 10 is reproduced. Thus, the simulation apparatus 110 executes simulation and predicts the state inside the furnace at each time.

Details of the prerequisite conditions set in the simulation apparatus 110, the growth conditions input to the simulation apparatus 110, and the state inside the furnace output from the simulation apparatus 110 will be described later.

A training program is installed in the training apparatus 120, and by executing the program, the training apparatus 120 functions as a training data generation unit 121 and a training unit 122.

The training data generation unit 121 acquires growth conditions input when the simulation apparatus 110 executes the simulation. The training data generation unit 121 acquires information indicating a state inside the furnace output when the simulation apparatus 110 executes the simulation. The training data generation unit 121 generates various combinations of training data in which the acquired growth conditions are input data and the acquired information indicating the state inside the furnace is ground truth and stores them in a training data storage unit 123 for each prerequisite condition.

The training unit 122 performs training processing of a model by using each training data stored in the training data storage unit 123 and generates each trained model.

A design assistance program is installed in the design assistance apparatus 130, and when the program is executed, the design assistance apparatus 130 functions as a display unit 131 and a prediction unit 132.

A display unit 131 provides a design assistance screen to a user 140. In response to the provision of the design assistance screen, the display unit 131 acquires:
· prerequisite conditions input by the user 140;
· prediction items which are items to be predicted among the information indicating the state inside the furnace; and
· growth conditions
and provides the prediction unit 132 with them. The display unit 131 obtains prediction results predicted by the prediction unit 132 in response to provision of the prerequisite conditions, the prediction items, and the growth conditions, and displays the prediction results to the user 140.

The prediction unit 132 reads the trained model generated by the training apparatus 120 and stored in the trained model storage unit 133, which is an example of the storage unit, in response to the prerequisite conditions, prediction items, and growth conditions provided from the display unit 131. The prediction unit 132 inputs the growth conditions provided from the display unit 131 to the read trained model to execute the trained model. The prediction unit 132 causes the read trained model to be executed, which provides the display unit 131 with information indicating the state inside the furnace corresponding to the prediction items output from the trained model.

As described above, the design assistance system 100 according to the first embodiment:
· generates training data by performing simulation using a simulation apparatus 110 reproducing a growth apparatus for growing an SiC single crystal by a sublimation method;
· generates a trained model (surrogate model) by using the generated training data and learning a relationship between the growth conditions and information indicating the state inside the furnace for each prerequisite condition; and
· predicts information indicating the state inside the furnace from the growth conditions by using the generated trained model.

Thus, according to the first embodiment, it is possible to predict the growth process of the SiC single crystal at a low computational cost, which in turn assists in smoothly designing growth conditions in the process for growing the SiC single crystal by the sublimation method.

### <OUTLINE OF GROWTH APPARATUS>

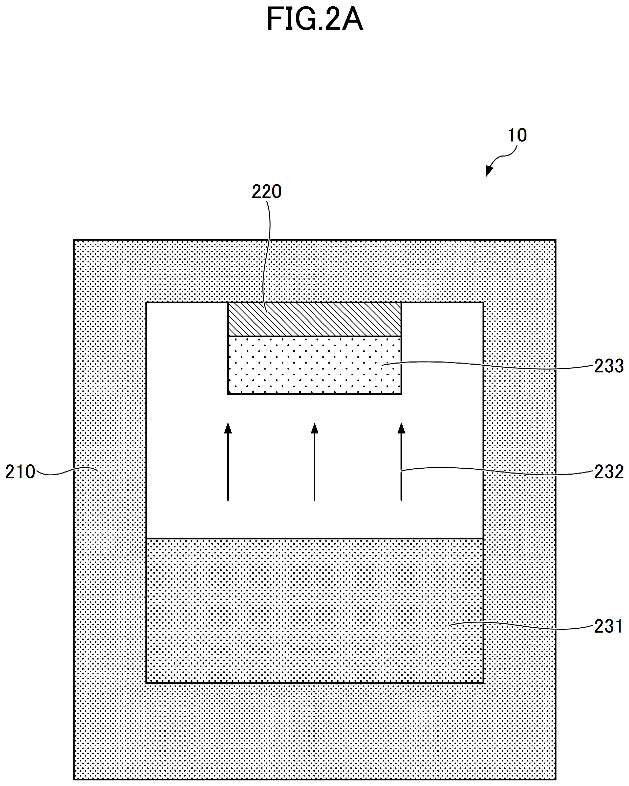

Next, an outline of the growth apparatus 10 (apparatus for growing SiC single crystal with sublimation method) reproduced by the simulation apparatus 110 will be described. FIG. 2A is a drawing illustrating an outline of a growth apparatus and illustrating a state in which a part of the sublimation furnace of the growth apparatus 10 is partially cut away to expose the inside of the furnace.

As shown in FIG. 2A, the sublimation furnace of the growth apparatus 10 includes a graphite crucible 210, and a seed crystal 220 is attached to a ceiling portion of the graphite crucible 210. SiC powder 231 as a raw material is deposited on the bottom of the graphite crucible 210, and the SiC powder 231 is heated by a heater, not shown, from the outside of the graphite crucible 210 to approximately 2300°C, for example. Thus, the SiC powder 231 sublimes and rises within the graphite crucible 210. A sublimed gas 232 that has risen recrystallizes on the seed crystal 220 to form an SiC single crystal 233. Generally, approximately 100 to 300 hours is required to grow an SiC single crystal 233.

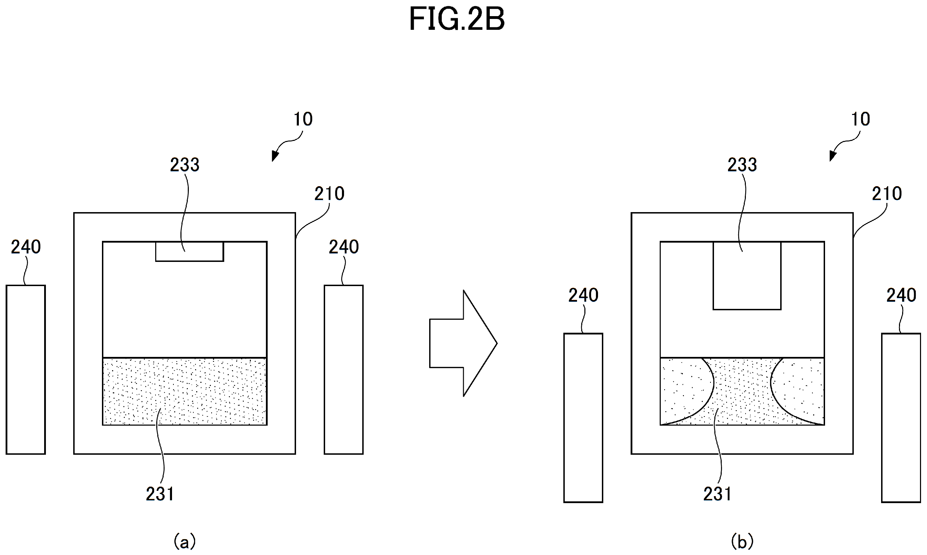

Next, the relationship between the growth conditions of the growth apparatus 10 and the state inside the sublimation furnace (hereinafter, simply referred to as "state inside the furnace") when the growth apparatus 10 grows the SiC single crystal 233 will be described. FIG. 2B is a drawing illustrating growth conditions and a state inside a furnace in the growth apparatus.

As shown in FIG. 2B, when the growth apparatus 10 grows the SiC single crystal 233, the growth conditions of the growth apparatus 10 include an output of the heater 240 for heating the SiC powder 231 from the outside of the graphite crucible 210 and a position of the heater 240.

By changing the output of the heater 240, the sublimation amount per unit time of the SiC powder 231 changes. By changing the position of the heater 240, a vertical position at which the SiC powder 231 is heated changes. In the growth apparatus 10, the output and the position of the heater 240 at each time are controlled so that the growth process of the SiC single crystal 233 becomes a desired growth process.

(a) of FIG. 2B shows the position of the heater 240 at the start of growth. At the position shown in (a) of FIG. 2B, when the heater 240 heats the SiC powder 231 for a certain duration and a part of the SiC powder 231 sublimes, the growth apparatus 10 changes the position of the heater 240.

(b) of FIG. 2B shows a state in which the position of the heater 240 is lowered from the position at the start of growing after a certain duration. (b) of FIG. 2B shows a state in which, after a certain duration, a part of the SiC powder 231 has sublimed, resulting in formation of a region where the raw material porosity has changed, and an increase in the amount of SiC single crystal 233 growth is observed.

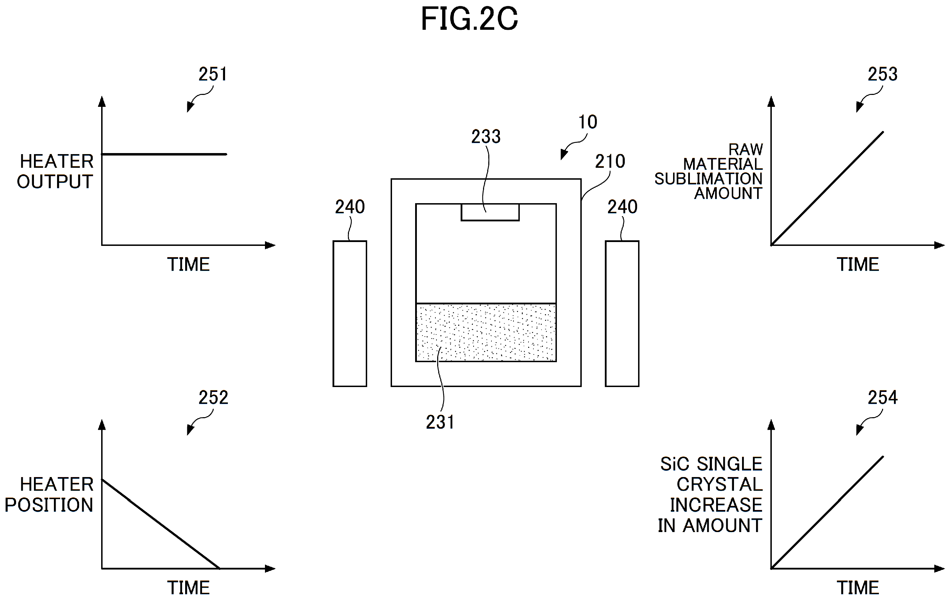

Next, the relationship between the changes with time of the growth conditions of the growth apparatus 10 and the changes with time of information indicating the state inside the furnace when the growth apparatus 10 grows the SiC single crystal 233 will be described. FIG. 2C is a drawing illustrating a relationship between changes with time in the growth conditions and changes with time in information indicating the state inside the furnace in the growth apparatus.

In FIG. 2C, a graph 251 schematically shows the changes with time of the heater output during the growth of the SiC single crystal 233, wherein the horizontal axis represents time and the vertical axis represents the heater output.

In FIG. 2C, a graph 252 schematically shows the changes with time of the heater position during the growing of the SiC single crystal 233, wherein the horizontal axis represents time and the vertical axis represents the heater position.

Additionally, in FIG. 2C, a graph 253 schematically shows the changes with time of the sublimation amount of the SiC powder 231 during the growth of the SiC single crystal 233, wherein the horizontal axis represents time and the vertical axis represents the raw material sublimation amount.

In FIG. 2C, a graph 254 schematically shows the changes with time of the increase of the SiC single crystal 233 in the amount during the growth of the SiC single crystal 233, wherein the horizontal axis represents time and the vertical axis represents the increase of the SiC single crystal in the amount.

In the growth apparatus 10, when the changes with time of the heater output shown in the graph 251 and the changes with time of the heater position shown in the graph 252 are adjusted, the changes with time of the raw material sublimation amount shown in the graph 253 is controlled. As a result, the changes with time of the SiC single crystal increase in the amount shown in the graph 254 is controlled.

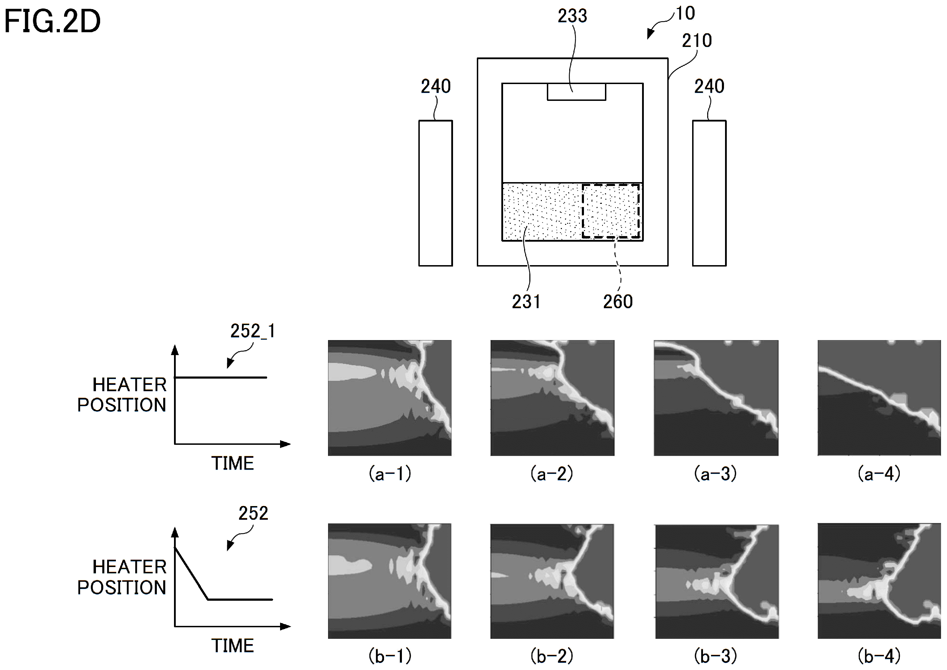

Next, the relationship between the changes with time of the growth conditions in the growth apparatus 10 and the changes with time of the information indicating the state inside the furnace will be described using specific examples. FIG. 2D is a drawing illustrating a specific example of a relationship between changes with time in the growth conditions and the changes with time in the information indicating the state inside the furnace in the growth apparatus.

In the example of FIG. 2D:
- the changes with time of the growth conditions in the growth apparatus 10 : the changes with time of the position of the heater 240; and
- the changes with time of the information indicating the state inside the furnace : the changes with time of the raw material sublimation amount at each position in the furnace,
will be described.

In FIG. 2D, (a-1) to (a-4) and (b-1) to (b-4) represent the raw material sublimation amount in the region indicated by the dotted line 260 at the bottom where the SiC powder 231 is deposited in the graphite crucible 210 constituting the sublimation furnace of the growth apparatus 10. In (a-1) to (a-4) and (b-1) to (b-4), red indicates that the SiC powder 231 has completely sublimed, and dark blue indicates that the SiC powder 231 has not sublimed. Light blue indicates that a part of the SiC powder 231 has sublimed, and the deeper the color, the larger the sublimed amount.

In FIG. 2D, time passes from (a-1) to (a-4). Similarly, in FIG. 2D, time passes from (b-1) to (b-4).

Here, (a-1) to (a-4) represent the amount of raw material sublimation in the region indicated by the dotted line 260 when the position of the heater 240 is changed with time as shown in graph 252_1.

Additionally, (b-1) to (b-4) represent the amount of raw material sublimation in the region indicated by the dotted line 260 when the position of the heater 240 is changed with time as shown in graph 252_2.

Thus, the changes with time in the information indicating the state inside the furnace also change depending on how the growth conditions change with time. As a result, the growth process of the SiC single crystal also changes. Therefore, in order to make the growth process of the SiC single crystal a desired growth process, it is required to appropriately change the growth conditions with time.

### <HARDWARE CONFIGURATION OF SIMULATION APPARATUS, TRAINING APPARATUS AND DESIGN ASSISTANCE APPARATUS>

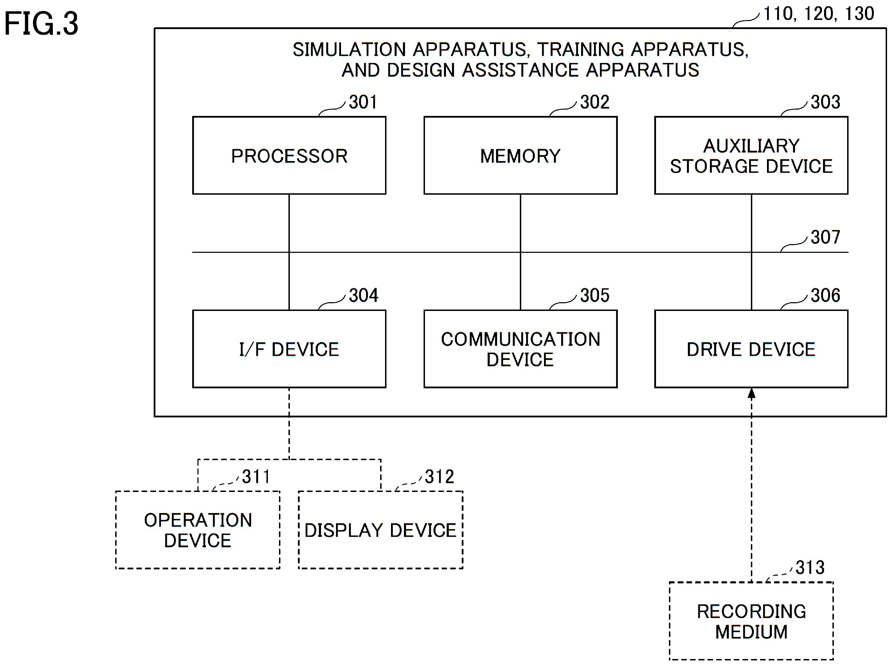

Next, the hardware configurations of the simulation apparatus 110, the training apparatus 120, and the design assistance apparatus 130 constituting the design assistance system 100 will be described. Since the simulation apparatus 110, the training apparatus 120, and the design assistance apparatus 130 have substantially similar hardware configurations, they will be described collectively with reference to FIG. 3.

FIG. 3 is a drawing illustrating an example of a hardware configuration of a simulation apparatus, a training apparatus, and a design assistance apparatus. As shown in FIG. 3, the simulation apparatus 110, the training apparatus 120, and the design assistance apparatus 130 each has a processor 301, a memory 302, an auxiliary storage device 303, an I/F (interface) device 304, a communication device 305, and a drive device 306. The respective hardware components of the simulation apparatus 110, the training apparatus 120, and the design assistance apparatus 130 are connected to each other via a bus 307.

The processor 301 has various computing devices such as a CPU (Central Processing Unit) and a GPU (Graphics Processing Unit). The processor 301 executes various programs (e.g., a simulation program, a training program, and a design assistance program) by reading them into the memory 302.

The memory 302 has a main storage device such as ROM (Read Only Memory) and RAM (Random Access Memory). The processor 301 and the memory 302 form what is called a computer, and the computer achieves various functions by executing various programs read from the memory 302 by the processor 301.

The auxiliary storage device 303 stores various programs and various data used when the various programs are executed by the processor 301. For example, the training data storage unit 123 and the trained model storage unit 133 are achieved in the auxiliary storage device 303.

The I/F device 304 is a connection device for connecting an operation device 311 and a display device 312, which are examples of user interface devices. The communication device 305 is a communication device for communicating with an external device via a network (not shown).

The drive device 306 is a device for setting a recording medium 313. Here, the recording medium 313 includes a medium for optically, electrically or magnetically recording information such as a CD-ROM, a flexible disk, a magneto-optical disk or the like. The recording medium 313 may include a semiconductor memory for electrically recording information such as a ROM, and a flash memory.

The various programs installed in the auxiliary storage device 303 are installed, for example, when a distributed recording medium 313 is set in the drive device 306 and the various programs recorded in the recording medium 313 are read by the drive device 306. Alternatively, the various programs installed in the auxiliary storage device 303 may be installed when they are downloaded from a network via the communication device 305.

### <SPECIFIC EXAMPLE OF PROCESSING OF SIMULATION APPARATUS>

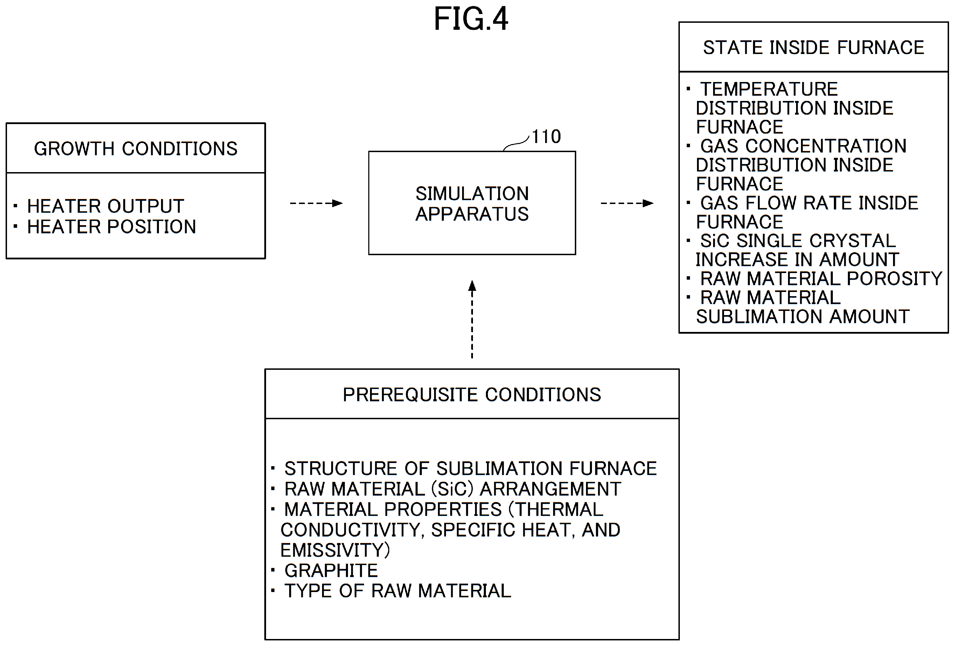

Next, a specific example of processing of the simulation apparatus 110 will be described. FIG. 4 is a drawing illustrating a specific example of processing of the simulation apparatus.

As described above, various prerequisite conditions are set in the simulation apparatus 110 to reproduce the target growth apparatus 10. As shown in FIG. 4, various prerequisite conditions set in the simulation apparatus 110 include such as:
- a structure of the sublimation furnace;
- arrangement of the SiC powder as a raw material;
- thermal conductivity, specific heat, and emissivity as material properties of each member included in the sublimation furnace;
- a type of graphite included in the graphite crucible; and
- a type of the SiC powder as the raw material.

Note that the example of FIG. 4 shows only a part of various prerequisite conditions set in the simulation apparatus 110, and many prerequisite conditions other than the example of FIG. 4 are set in the simulation apparatus 110.

As described above, various growth conditions are input to the simulation apparatus 110 on the simulation. As shown in FIG. 4, the growth conditions input to the simulation apparatus 110 include a heater output, a heater position, and the like.

Note that the example of FIG. 4 shows only a part of the growth conditions input to the simulation apparatus 110, and growth conditions other than the example of FIG. 4 may be input to the simulation apparatus 110.

As described above, the simulation apparatus 110 predicts information indicating a state inside the furnace by simulation. As shown in FIG. 4, the information indicating the state inside the furnace predicted by the simulation apparatus 110 includes a temperature distribution inside the furnace, a gas concentration distribution inside the furnace, a gas flow rate inside the furnace, an SiC single crystal increase in the amount, raw material porosity, a raw material sublimation amount, and the like. Among them, the temperature distribution inside the furnace, the gas concentration distribution inside the furnace, the gas flow velocity in the furnace, the raw material porosity, etc. are examples of the first-item data indicating the state inside the furnace at each time at each position in the furnace. The combination of the first-item data and the second-item data when the second-item data correlated to the first-item data is derived from the first-item data includes the combination of the temperature distribution inside the furnace and the raw material porosity, and the combination of the raw material sublimation amount and the SiC single crystal increase in the amount.

The raw material porosity refers to the sublimation ratio of SiC as a raw material at each position in the furnace. The raw material sublimation amount is a value obtained by totaling the sublimation amounts at each position calculated from the sublimation ratio at each position in the furnace for all positions. The increase in the amount of the SiC single crystal is expressed by the thickness of the SiC single crystal or the volume of the SiC single crystal.

### <FUNCTIONAL CONFIGURATION OF TRAINING APPARATUS>

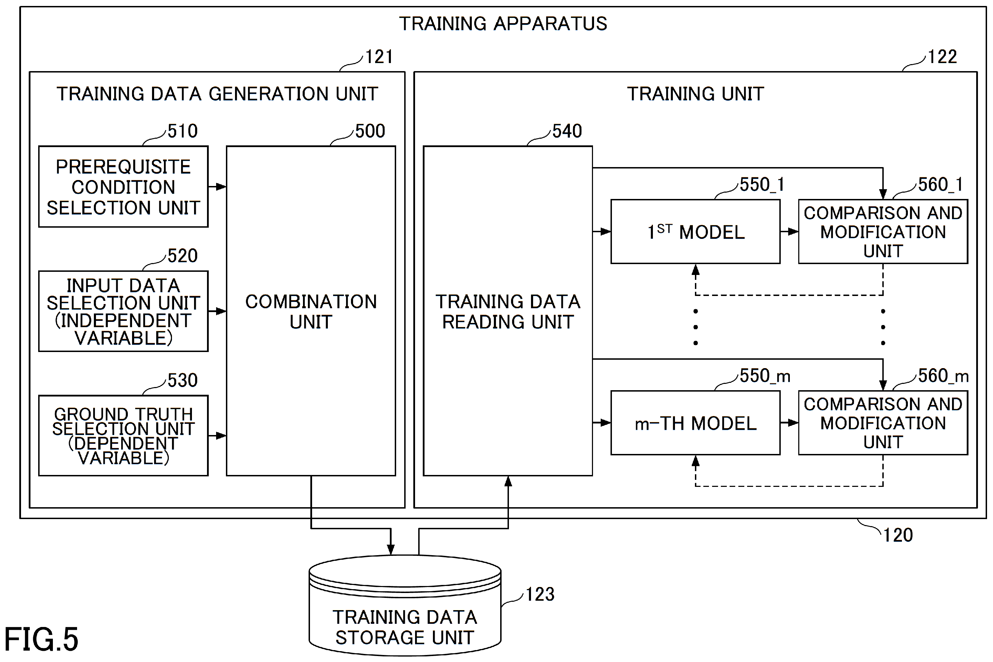

Next, the functional configuration of the training apparatus 120 will be described in detail. FIG. 5 is a drawing illustrating an example of a functional configuration of the training apparatus.

As described above, the training apparatus 120 functions as a training data generation unit 121 and a training unit 122. The training data generation unit 121 has a prerequisite condition selection unit 510, an input data selection unit 520, a ground truth selection unit 530, and a combination unit 500. The training unit 122 includes a training data reading unit 540, a first model 550_1 to an m-th model 550_m, and comparison and modification units 560_1 to 560_m (m is an integer greater than or equal to 2).

The prerequisite condition selection unit 510 receives prerequisite conditions input when the simulation is executed by the simulation apparatus 110. When the simulation is executed under different prerequisite conditions, the respective prerequisite conditions are input.

The input data selection unit 520 receives growth conditions input when the simulation is executed by the simulation apparatus 110.

A ground truth selection unit 530 is input with information indicating a state inside the furnace output during simulation by the simulation apparatus 110.

A combination unit 500 combines:
- prerequisite conditions input by the prerequisite condition selection unit 510;
- growth conditions input by the input data selection unit 520; and
- information indicating the state inside the furnace input by the ground truth selection unit 530.
The combination unit 500 stores training data, in which the combined growth condition and the information indicating the state inside the furnace are input data and ground truth, respectively, in the training data storage unit 123 separately for each prerequisite condition.

A training data reading unit 540 reads the training data stored in the training data storage unit 123. The training data reading unit 540 inputs input data included in the read training data to any one of the first model 550_1 to the m-th model 550_m. The training data reading unit 540 inputs ground truth included in the read training data to any one of the comparison and modification units 560_1 to 560_m.

The first model 550_1 to the m-th model 550_m outputs the output data by receiving the input data from the training data reading unit 540.

The comparison and modification units 560_1 to 560_m compare output data output from each of the first model 550_1 to the m-th model 550_m with the ground truth input by the training data reading unit 540. The comparison and modification units 560_1 to 560_m update the model parameters of the first model 550_1 to the m-th model 550_m according to the comparison result.

Thus, the training unit 122 generates the first trained model to the m-th trained model.

The first trained model to the m-th trained model are configured by, for example, RNNs (Recurrent Neural Network). However, an algorithm for configuring the first trained model to the m-th trained model is not limited to an RNN. The first trained model to the m-th trained model are configured by, for example:
- LSTM (Long Short Term Memory);
- GRU (Gated Recurrent Unit);
- Seq2Seq;
- Bidirectional RNN;
- Seq2Seq with Attention mechanism;
- Transformer,
and other recurrent neural networks.

### <SPECIFIC EXAMPLES OF TRAINING DATA>

### (1) FIRST TRAINING DATA

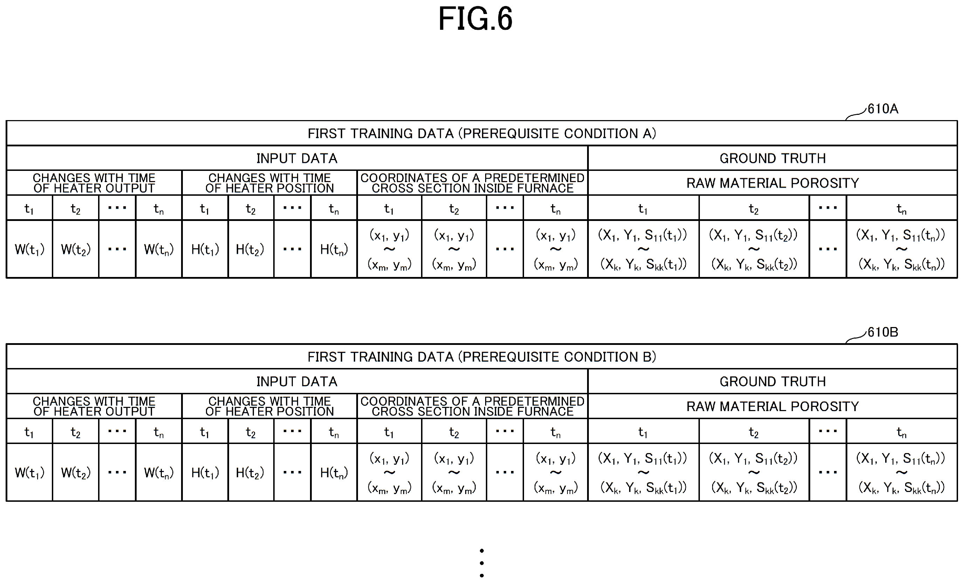

Next, a specific example of the first training data generated by the training data generation unit 121 will be described. FIG. 6 is a first drawing illustrating examples of training data.

In FIG. 6, input data of first training data 610A, first training data 610B, ..., include:
- datasets of the heater outputs W(t₁) to W(tₙ) at respective times t₁ to tₙ, as the changes with time of the heater output;
- datasets of the heater positions H(t₁) to H(tₙ) at respective times t₁ to tₙ, as the changes with time of the heater position; and
- datasets from (x₁, y₁) to (xₘ, yₘ), which are associated with respective times t₁ to tₙ, as coordinates of a predetermined cross section inside the furnace.

In FIG. 6, the ground truth of the first training data 610A, the first training data 610B, ..., include
- datasets from the raw material porosity S₁₁(t₁) to Sₖₖ(t₁) at the respective coordinates (X₁, Y₁) to (Xₖ, Yₖ) at the time t₁, to raw material porosity S₁₁(tₙ) to Sₖₖ(tₙ) at the respective coordinates (X₁, Y₁) to (Xₖ, Yₖ) at the time tₙ, as the changes with time of the raw material porosity.

Note that the first training data 610A shown in FIG. 6 is training data obtained by executing simulation after "prerequisite condition A" is set in the simulation apparatus 110. The first training data 610B shown in FIG. 6 is training data obtained by executing simulation after "prerequisite condition B" is set in the simulation apparatus 110.

### (2) SECOND TRAINING DATA

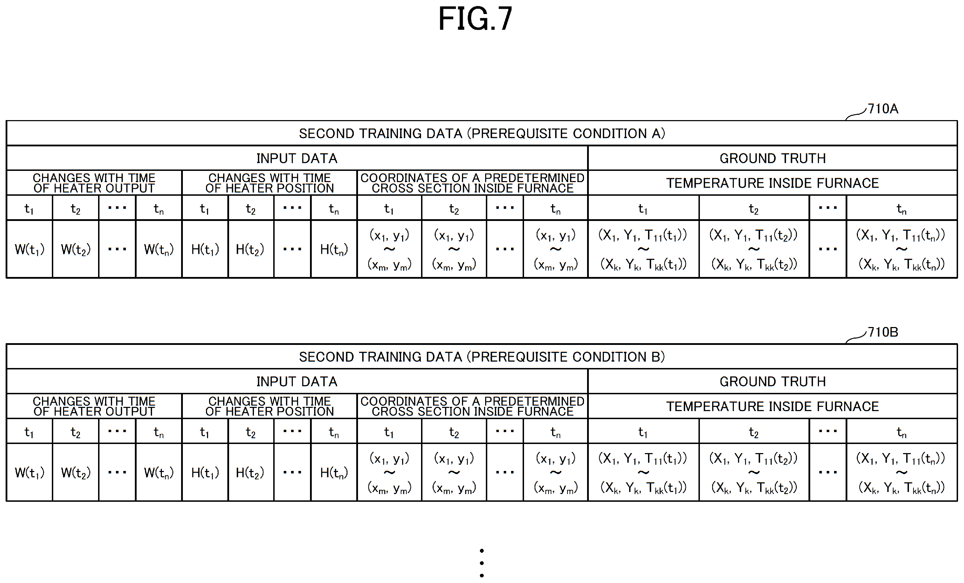

Next, a specific example of the second training data generated by the training data generation unit 121 will be described. FIG. 7 is a second drawing illustrating examples of the training data.

In FIG. 7, input data of second training data 710A, second training data 710B, ..., include:
- heater outputs W(t₁) to W(tₙ) at respective times t₁ to tₙ, as the changes with time of the heater output;
- datasets of heater positions H(t₁) to H(tₙ) at respective times t₁ to tₙ, as the changes with time of the heater position; and
- datasets from (x₁, y₁) to (xₘ, yₘ), which are associated with respective times t₁ to tₙ, as coordinates of a predetermined cross section inside the furnace.

In FIG. 7, the ground truth of the second training data 710A, the second training data 710B, ..., include
- datasets from the temperature inside the furnace T₁₁(t₁) to Tₖₖ(t₁) at the respective coordinates (X₁, Y₁) to (Xₖ, Yₖ) at the time t₁, to the temperature inside the furnace T₁₁(tₙ) to Tₖₖ(tₙ) at the respective coordinates (X₁, Y₁) to (Xₖ, Yₖ) at the time tₙ, as the changes with time of the temperature inside the furnace.

Note that the second training data 710A shown in FIG. 7 is training data obtained by executing simulation after "prerequisite condition A" is set in the simulation apparatus 110. The second training data 710B shown in FIG. 7 is training data obtained by executing simulation after "prerequisite condition B" is set in the simulation apparatus 110.

### (3) THIRD TRAINING DATA

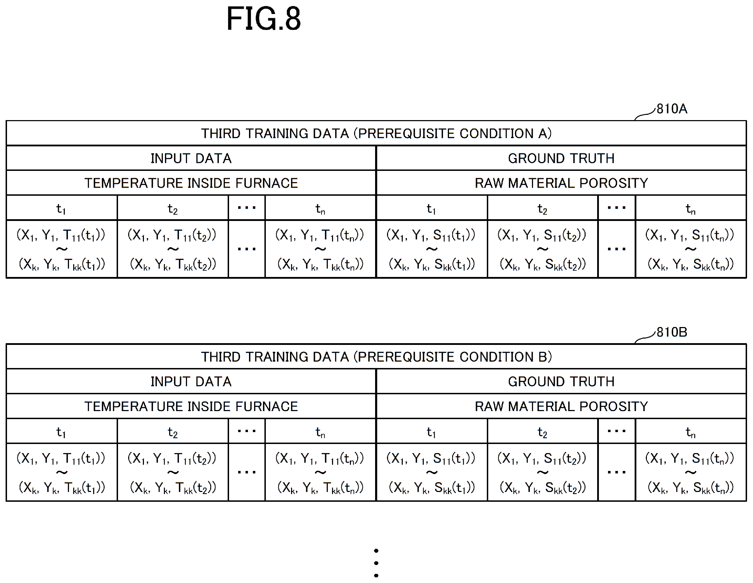

Next, a specific example of the third training data generated by the training data generation unit 121 will be described. FIG. 8 is a third drawing illustrating an example of training data.

In FIG. 8, input data of third training data 810A, third training data 810B, ..., include:
- datasets from the temperature inside the furnace T₁₁(t₁) to Tₖₖ(t1) at the respective coordinates (X₁, Y₁) to (Xₖ, Yₖ) at the time t₁, to the temperature inside the furnace T₁₁(tₙ) to Tₖₖ(tₙ) at the respective coordinates (X₁, Y₁) to (Xₖ, Yₖ) at the time tₙ, as the changes with time of the temperature inside the furnace.

In FIG. 8, the ground truth of the third training data 810A, the third training data 810B, ..., include
- datasets from the raw material porosity S₁₁(t₁) to Sₖₖ(t₁) at the respective coordinates (X₁, Y₁) to (Xₖ, Yₖ) at the time t₁, to the raw material porosity S₁₁(tₙ) to Sₖₖ(tₙ) at the respective coordinates (X₁, Y₁) to (Xₖ, Yₖ) at the time tₙ, as the changes with time of the raw material porosity.

Note that the third training data 810A shown in FIG. 8 is training data obtained by executing simulation after "prerequisite condition A" is set in the simulation apparatus 110. The third training data 810B shown in FIG. 8 is training data obtained by executing simulation after "prerequisite condition B" is set in the simulation apparatus 110.

### (4) FOURTH TRAINING DATA

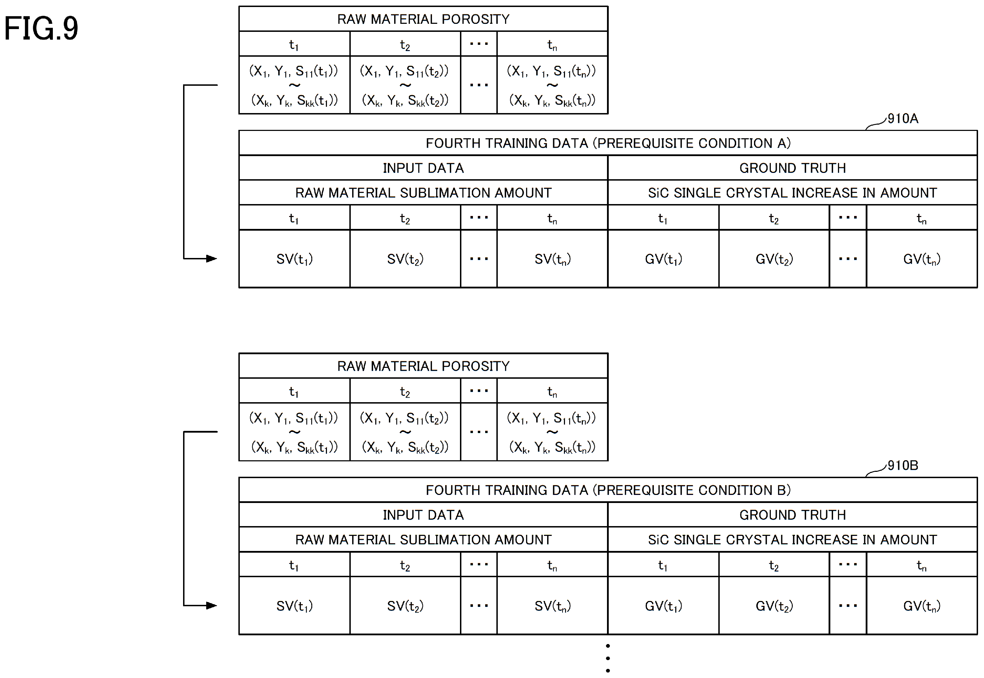

Next, a specific example of the fourth training data generated by the training data generation unit 121 will be described. FIG. 9 is a fourth drawing illustrating an example of training data.

In FIG. 9, input data of fourth training data 910A, fourth training data 910B, ..., store change with time of the raw material sublimation amount.

The change with time of the raw material sublimation amount is calculated based on
- the raw material porosity S₁₁(t₁) to Sₖₖ(t₁) at the respective coordinates (X₁, Y₁) to (Xₖ, Yₖ) at the time t₁, and the raw material porosity S₁₁(tₙ) to Sₖₖ(tₙ) at the respective coordinates (X₁, Y₁) to (Xₖ, Yₖ) at the time tₙ, as the changes with time of the raw material porosity, and
the change with time of the raw material sublimation amount includes
- datasets of the raw material sublimation amount SV(t₁) to SV(tₙ) at respective times t₁ to tₙ.

In FIG. 9, input data of fourth training data 910A, fourth training data 910B, ..., includes
- SiC single crystal increase in the amount at each time t₁ to tₙ: GV(t₁) to GV(tₙ).

Note that the fourth training data 910A shown in FIG. 9 is training data obtained by executing simulation after "prerequisite condition A" is set in the simulation apparatus 110. The fourth training data 910B shown in FIG. 9 is training data obtained by executing simulation after "prerequisite condition B" is set in the simulation apparatus 110.

### <FLOW OF TRAINING DATA GENERATION PROCESSING AND TRAINING PROCESSING>

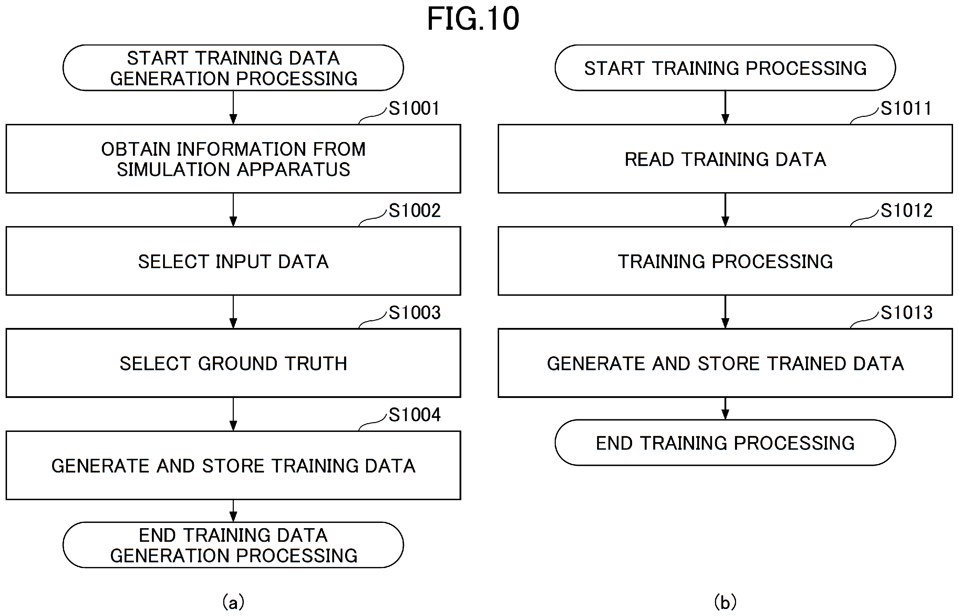

Next, a flow of training data generation processing and training processing performed by the training apparatus 120 will be described. FIG. 10 is a flowchart illustrating the flow of training data generation processing and training processing.

As shown in FIG. 10 (a), when the training data generation processing is started, in a step S1001, the training apparatus 120 obtains information indicating the growth conditions and the state inside the furnace from the simulation apparatus 110 for each prerequisite condition. Here, for the sake of simplification, a case where information indicating the growth conditions and the state inside the furnace is obtained when the simulation is performed after the prerequisite condition A is set will be described.

In a step S1002, the training apparatus 120 selects input data to be used as training data from the information indicating the growth conditions and the state inside the furnace obtained from the simulation apparatus 110.

In a step S1003, the training apparatus 120 selects ground truth to be used as training data from the information indicating the growth conditions and the state inside the furnace obtained from the simulation apparatus 110.

In a step S1004, the training apparatus 120 generates training data by combining the selected input data and the selected ground truth, and stores it in the training data storage unit 123. At this time, when the ground truth is two-dimensional data and the input data is one-dimensional data, the training apparatus 120 includes coordinate data in the input data.

As shown in FIG. 10 (b), when the training processing is started, in a step S1011, the training apparatus 120 reads the training data from the training data storage unit 123.

In a step S1012, the training apparatus 120 performs a training processing on the model by using the training data.

In a step S1013, the training apparatus 120 generates a trained model and stores it in the trained model storage unit 133 of the design assistance apparatus 130.

Although an order of execution of the training data generation processing for the first training data to the fourth training data is not described in FIG. 10 (a), the training data generation processing may be executed in any order. For example, after the training data generation processing for the third training data is executed, the training data generation processing for the fourth training data may be executed.

Similarly, although an order of execution of the training processing for the first model to the fourth model is not described in FIG. 10 (b), the training data generation processing may be executed in any order. For example, after the training processing for the third model is executed, the training processing for the fourth model may be executed.

### <SPECIFIC EXAMPLE OF TRAINING PROCESSING>

Next, a specific example of the training processing by the training unit 122 will be described. As described with reference to FIGS. 6 to 9, in the first embodiment, the training data generation unit 121 generates the fourth training data 910A from the first training data 610A for "prerequisite condition A".

Therefore, in describing a specific example of the training processing by the training unit 122, a case where the training processing of the first model to the fourth model is performed using the first training data 610A to the fourth training data 910A for "prerequisite condition A" will be described.

### (1) TRAINING PROCESSING OF FIRST MODEL

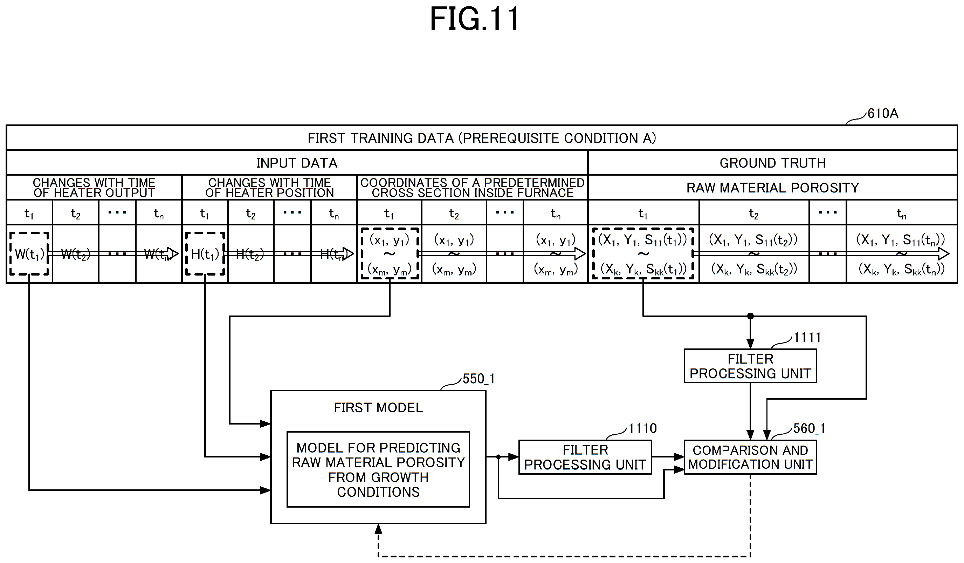

First, as a specific example of the training processing by the training unit 122, a case where the training processing is performed on the first model 550_1 using the first training data 610A for "prerequisite condition A" will be described. FIG. 11 is a first drawing illustrating a specific example of the training processing by a training unit.

As shown in FIG. 11, the first model 550_1 is a model for predicting raw material porosity from growth conditions. The training unit 122 sequentially inputs:
- changes with time of heater output: W(t);
- changes with time of heater position: H(t); and
- coordinates at a specific cross section in the furnace: (x₁, y₁) to (xₘ, yₘ),
included in the output data of the first training data 610A, into the first model 550_1 from time t₁. As a result, output data are sequentially output from the first model 550_1 and provided to a filter processing unit 1110 and a comparison and modification unit 560_1, respectively. When the filter processing unit 1110 applies an image processing filter to each output data, the training unit 122 can perform training processing in which correlation between output data at adjacent coordinates is increased. In the filter processing unit 1110, for example, a function of a finite difference approximation filter used in general image processing is applied as an image processing filter. The finite difference approximation filter is also called a differential filter and includes a Sobel filter, a Laplacian filter, and the like.

- Raw material porosity ratio at each coordinate at each time included in the ground truth of the first training data 610A: (X₁, Y₁, S₁₁(t)) to (Xₖ, Yₖ, Sₖₖ(t)); and
- raw material porosity ratio at each coordinate at each time included in the ground truth of the first training data 610A: (X₁, Y₁, S₁₁(t)) to (Xₖ, Yₖ, Sₖₖ(t)), which is raw material porosity ratio at each coordinate at each time when the image processing filter is applied by the filter processing unit 1111,
are sequentially input into the comparison and modification unit 560_1 from the time t₁.

A comparison and modification unit 560_1 compares output data sequentially output from the first model 550_1 with ground truth to calculate differences. The comparison and modification unit 560_1 compares output data sequentially output from the filter processing unit 1110 after applying the image processing filter with ground truth sequentially output from the filter processing unit 1111 after applying the image processing filter to calculate differences. The comparison and modification unit 560_1 has a loss function capable of calculating differences. The comparison and modification unit 560_1 performs weighted addition of the aforementioned two types of differences and uses the difference obtained by the weighted addition as the result of the loss function value. The comparison and modification unit 560_1 generates a first trained model by updating the model parameter of the first model 550_1 so as to minimize the calculation result. The first trained model is stored in a trained model storage unit 133 functioning as a first storage unit.

By performing training processing using output data after applying the image processing filter, it is possible to prevent the porosity at adjacent coordinates from becoming unnaturally discontinuous value. The training processing may be performed without using the output data after the image processing filter is applied.

### (2) TRAINING PROCESSING OF SECOND MODEL

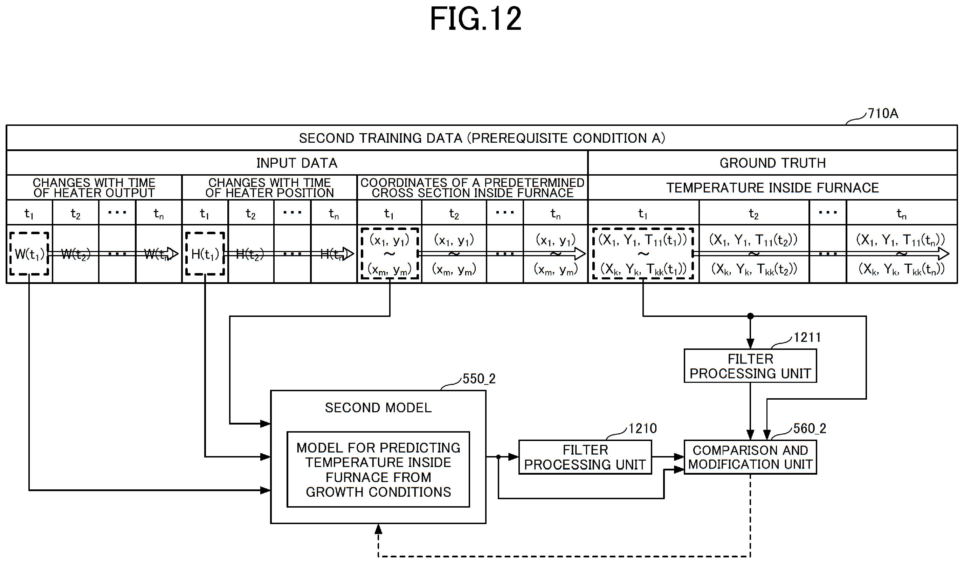

Next, as a specific example of the training processing by the training unit 122, a case where the training processing is performed on the second model 550_2 using the second training data 710A for "prerequisite condition A" will be described. FIG. 12 is a second drawing illustrating a specific example of the training processing by the training unit.

As shown in FIG. 12, the second model 550_2 is a model for predicting the temperature inside the furnace from growth conditions. The training unit 122 sequentially inputs:
· changes with time of heater output: W(t);
· changes with time of heater position: H(t); and
· coordinates at a specific cross section in the furnace: (x₁, y₁) to (xₘ, yₘ),
included in the output data of the second training data 710A, into the second model 550_2 from time t₁. As a result, output data are sequentially output from the second model 550_2 and provided to a filter processing unit 1210 and a comparison and modification unit 560_2, respectively. When the filter processing unit 1210 applies an image processing filter to each output data, the training unit 122 can perform training processing in which correlation between output data at adjacent coordinates is increased. In the filter processing unit 1210, the same image processing filter as in the filter processing unit 1110 in FIG. 11 is applied.

- Temperature inside the furnace at each coordinate at each time included in the ground truth of the second training data 710A: (X₁, Y₁, T₁₁(t)) to (Xₖ, Yₖ, Tₖₖ(t)); and
- temperature inside the furnace at each coordinate at each time included in the ground truth of the second training data 710A: (X₁, Y₁, T₁₁(t)) to (Xₖ, Yₖ, Tₖₖ(t)), which is temperature inside the furnace at each coordinate at each time when the image processing filter is applied by the filter processing unit 1211,
are sequentially input into the comparison and modification unit 560_2 from the time t₁.

A comparison and modification unit 560_2 compares output data sequentially output from the second model 550_2 with ground truth to calculate differences. The comparison and modification unit 560_2 compares output data sequentially output from the filter processing unit 1210 after applying the image processing filter with ground truth sequentially output from the filter processing unit 1211 after applying the image processing filter to calculate differences. The comparison and modification unit 560_2 has a loss function capable of calculating differences. The comparison and modification unit 560_2 performs weighted addition of the two types of differences and uses the difference obtained by the weighted addition as the result of the loss function value. The comparison and modification unit 560_2 generates a second trained model by updating the model parameter of the second model 550_2 so as to minimize the calculation result. The second trained model is stored in a trained model storage unit 133 functioning as a second storage unit.

By performing training processing using output data after applying the image processing filter, it is possible to prevent the porosity at adjacent coordinates from becoming unnaturally discontinuous values. The training processing may be performed without using the output data after the image processing filter is applied.

### (3) TRAINING PROCESSING OF THIRD MODEL

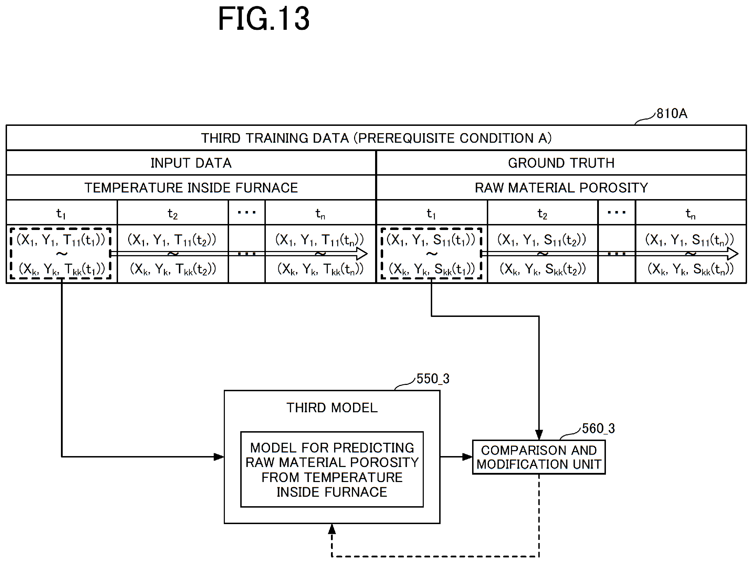

Next, as a specific example of the training processing by the training unit 122, a case where the training processing is performed on the third model 550_3 using the third training data 810A for "prerequisite condition A" will be described. FIG. 13 is a third drawing illustrating a specific example of the training processing by the training unit.

As shown in FIG. 13, the third model 550_3 is a model for predicting raw material porosity from temperature inside the furnace. The training unit 122 sequentially inputs:
· furnace temperature at each coordinate at each time: (X₁, Y₁, T₁₁(t)) to (Xₖ, Yₖ, Tₖₖ(t))
included in the output data of the third training data 810A, into the third model 550_3 from time t₁. As a result, output data are sequentially output from the third model 550_3.

· Raw material porosity ratio at each coordinate at each time included in the ground truth of the third training data 810A: (X₁, Y₁, S₁₁(t)) to (Xₖ, Yₖ, Sₖₖ(t))
is sequentially input into the comparison and modification unit 560_3 from the time t₁.

Thus, the comparison and modification unit 560_3 compares the data with the output data sequentially output from the third model 550_3 and calculates a difference. The comparison and modification unit 560_3 has a loss function capable of calculating a difference, updates the model parameters of the third model 550_3 so as to minimize the difference as the calculation result of the loss function, and generates a third trained model. The third trained model is stored in a trained model storage unit 133 functioning as a third storage unit.

### (4) TRAINING PROCESSING OF FOURTH MODEL

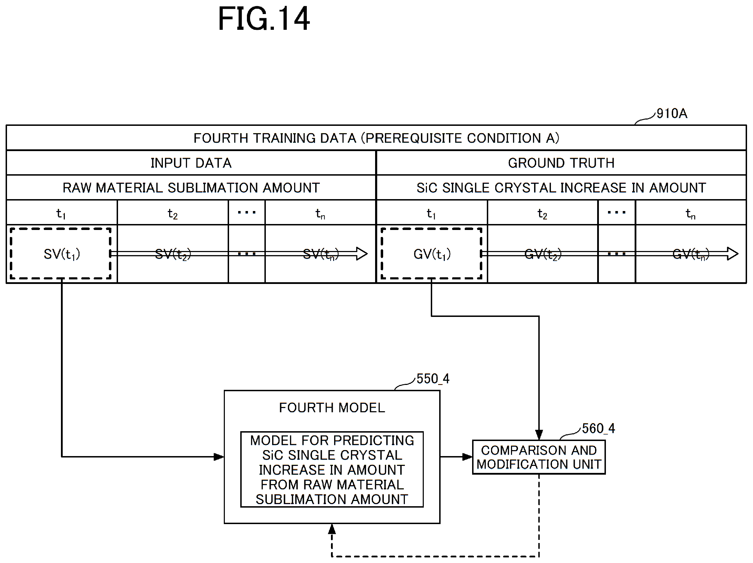

Next, as a specific example of the training processing by the training unit 122, a case where the training processing is performed on the fourth model 550_4 using the fourth training data 910A for "prerequisite condition A" will be described. FIG. 14 is a fourth drawing illustrating a specific example of the training processing by the training unit.

As shown in FIG. 14, the fourth model 550_4 is a model for predicting SiC single crystal increase in the amount from raw material sublimation amount. The training unit 122 sequentially inputs:
· raw material sublimation amount at each time: SV(t) included in the output data of the fourth training data 910A, into the fourth model 550_4 from time t₁. As a result, output data are sequentially output from the fourth model 550_4.

- SiC single crystal increase in the amount at each time included in the ground truth of the fourth training data 910A: GV(t)
is sequentially input into the comparison and modification unit 560_4 from the time t₁.

Thus, the comparison and modification unit 560_4 compares the data with the output data sequentially output from the fourth model 550_4 and calculates a difference. The comparison and modification unit 560_4 has a loss function capable of calculating a difference, updates the model parameters of the fourth model 550_4 so as to minimize the difference as the calculation result of the loss function, and generates a fourth trained model. The fourth trained model is stored in a trained model storage unit 133 functioning as a fourth storage unit.

### <FUNCTIONAL CONFIGURATION OF DESIGN ASSISTANCE APPARATUS>

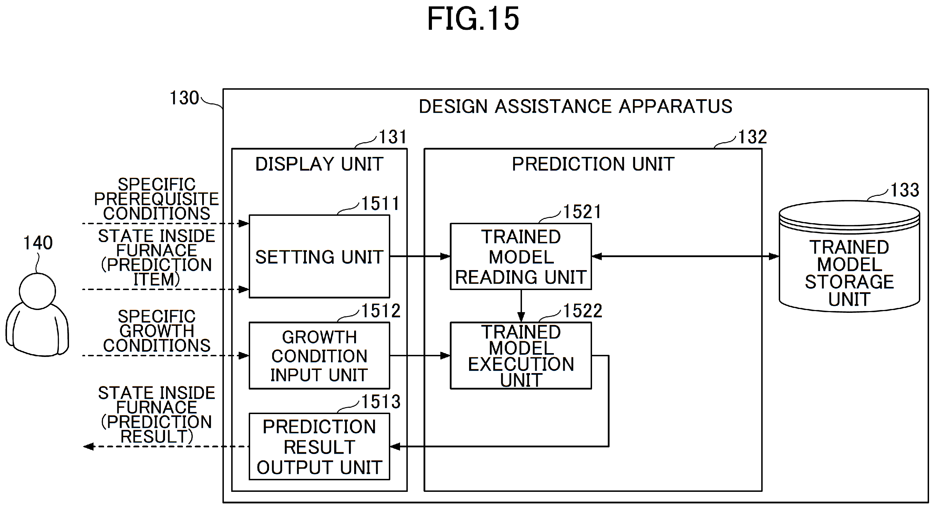

Next, the functional configuration of the design assistance apparatus 130 will be described in detail. FIG. 15 is a first drawing illustrating an example of a functional configuration of a design assistance apparatus.

As described above, the design assistance apparatus 130 functions as the display unit 131 and the prediction unit 132. The display unit 131 includes a setting unit 1511, a growth condition input unit 1512, and a prediction result output unit 1513. The prediction unit 132 includes a trained model reading unit 1521 and a trained model execution unit 1522.

The setting unit 1511 sets, in the trained model reading unit 920, prerequisite conditions and information corresponding to prediction items to be confirmed by the user 140 among information indicating a state inside the furnace.

When growth conditions are input by the user 140 in response to the display of the design assistance screen by the display unit 131, the growth condition input unit 1512 receives the input. The growth condition input unit 1512 provides the trained model execution unit 1522 with the received growth conditions.

In response to the growth conditions being provided to the trained model execution unit 1522 by the growth condition input unit 1512, the prediction result output unit 1513 obtains information indicating the state inside the furnace predicted by the trained model execution unit 1522. The prediction result output unit 1513 displays the obtained information indicating the state inside the furnace to the user 140 by using a design assistance screen.

The trained model reading unit 1521 reads the trained model from the trained model storage unit 133 based on information corresponding to the prerequisite conditions and the prediction items set by the setting unit 1511.

The trained model reading unit 1521 provides the trained model execution unit 1522 with the read trained model.

The trained model execution unit 1522 inputs the growth conditions provided by the growth condition input unit 1512 to the trained model provided from the trained model reading unit 1521. Thus, the trained model execution unit 1522 operates the trained model and predicts information indicating the state inside the furnace.

The trained model execution unit 1522 provides the prediction result output unit 1513 with the information indicating the state inside the furnace predicted by the trained model.

In this manner, the design assistance system 100 according to the first embodiment predicts the information indicating the state inside the furnace when growing the SiC single crystal by the sublimation method using the trained model. Thus, according to the design assistance system 100 according to the first embodiment, the information indicating the state inside the furnace can be predicted at a low computational cost, and it is possible to assist in smoothly designing growth conditions in the process for growing the SiC single crystal by the sublimation method.

### <VARIATION OF PREDICTION PROCESSING>

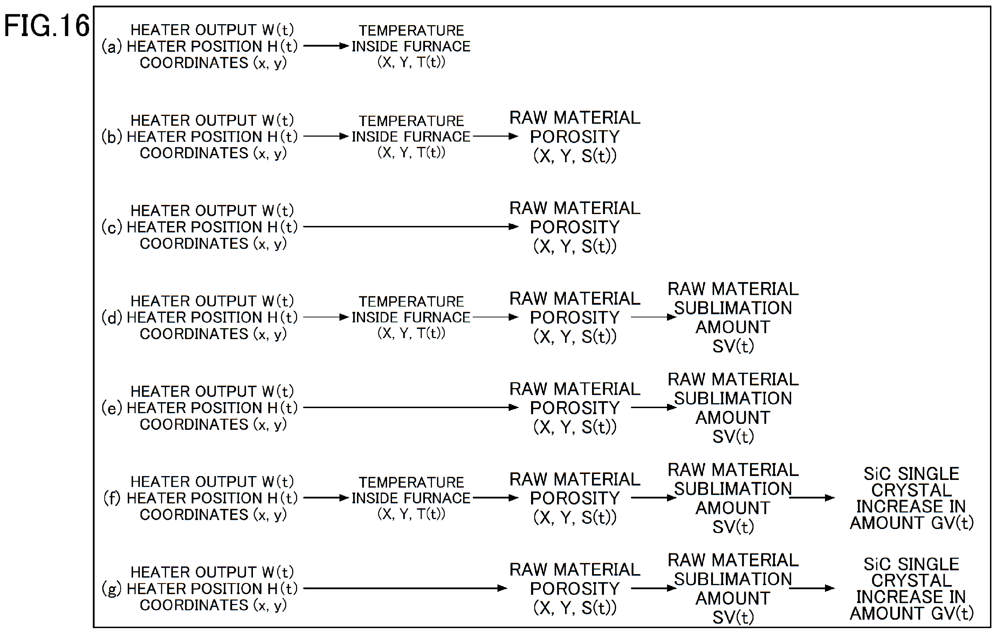

Next, variations of prediction processing when the prediction unit 132 performs prediction processing using the first to fourth trained models will be described. FIG. 16 is a drawing illustrating variation of prediction processing by a prediction unit.

FIG. 16 (a) illustrates prediction processing for predicting
· changes with time of temperature at each coordinate in the furnace: (X, Y, T(t)) by inputting:
   · changes with time of heater output: W(t); and
   · changes with time of heater position: H(t),
   into the second trained model generated with the training processing shown in FIG. 12.

FIG. 16 (b) illustrates prediction processing for predicting
- changes with time of temperature at each coordinate in the furnace: (X, Y, T(t))
by inputting:
- changes with time of heater output: W(t); and
- changes with time of heater position: H(t),
into the second trained model generated with the training processing shown in FIG. 12, and predicting
- changes with time of raw material porosity at each coordinate in the furnace: (X, Y, S(t))
by inputting
- predicted changes with time of temperature at each coordinate in the furnace: (X, Y, T(t))
into the third trained model generated with the training processing shown in FIG. 13.

FIG. 16 (c) illustrates prediction processing for predicting
- changes with time of raw material porosity at each coordinate in the furnace: (X, Y, S(t))
by inputting:
- changes with time of heater output: W(t); and
- changes with time of heater position: H(t),
into the first trained model generated with the training processing shown in FIG. 11.

FIG. 16 (d) illustrates prediction processing for calculating
- changes with time of raw material sublimation amount: SV(t)
based on the predicted changes with time of raw material porosity at each coordinate in the furnace: (X, Y, S(t)) after executing the prediction processing shown in FIG. 16 (b).

FIG. 16 (e) illustrates prediction processing for calculating
- changes with time of raw material sublimation amount: SV(t)
based on the predicted changes with time of raw material porosity at each coordinate in the furnace: (X, Y, S(t)) after executing the prediction processing shown in FIG. 16 (c).

FIG. 16 (f) illustrates prediction processing for predicting
- changes with time of SiC single crystal increase in the amount: GV(t)
by inputting:
- predicted changes with time of raw material sublimation amount: SV(t)
into the fourth trained model generated with the training processing shown in FIG. 14 after executing the prediction processing shown in FIG. 16 (d).

FIG. 16 (g) illustrates prediction processing for predicting
- changes with time of SiC single crystal increase in the amount: GV(t)
by inputting:
- predicted changes with time of raw material sublimation amount: SV(t)
into the fourth trained model generated with the training processing shown in FIG. 16 after executing the prediction processing shown in FIG. 16 (e).

### <SPECIFIC EXAMPLES OF PREDICTION PROCESSING BY PREDICTION UNIT>

Next, specific examples of prediction processing by the prediction unit 132 will be described. As described with reference to FIG. 16, in the first embodiment, the prediction unit 132 executes seven types of prediction processing (a) to (g) by using the first to fourth trained models. As specific examples of the seven types of prediction processing by the prediction unit 132, prediction processing using the first to fourth trained models will be described.

### (1) PREDICTION PROCESSING USING FIRST TRAINED MODEL

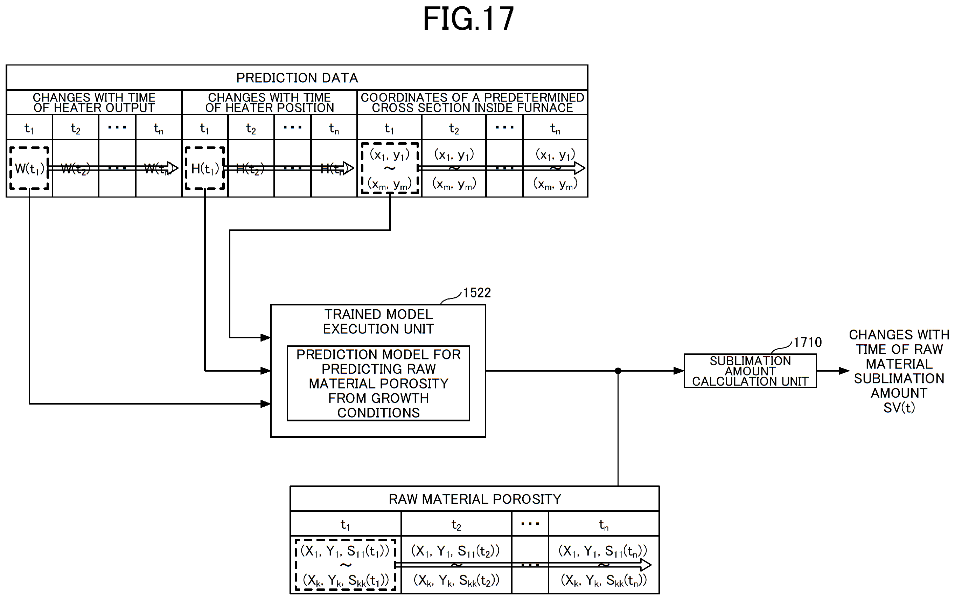

First, a specific example of prediction processing using the first trained model will be described. FIG. 17 is a first drawing illustrating a specific example of the prediction processing by the prediction unit.

As shown in FIG. 17, the trained model execution unit 1522 reads a "prediction model for predicting raw material porosity from growth conditions" as the first trained model, and sequentially inputs prediction data:
- changes with time of heater output: W(t);
- changes with time of heater position: H(t); and
- coordinates at a specific cross-section in the furnace: (x₁, y₁) to (xₘ, yₘ)
from time t₁. Thus, the "prediction model for predicting raw material porosity from growth conditions", which is an example of the first trained model sequentially outputs
- raw material porosity at each coordinate at each time: (X₁, Y₁, S₁₁(t)) to (Xₖ, Yₖ, Sₖₖ(t))
from time t₁.

A sublimation amount calculation unit 1710 calculates the changes with time SV(t) of the raw material sublimation amount by summing the raw material porosity at each coordinate at each time sequentially output from the trained model execution unit 1522 for all coordinates.

### (2) PREDICTION PROCESSING USING SECOND AND THIRD TRAINED MODEL

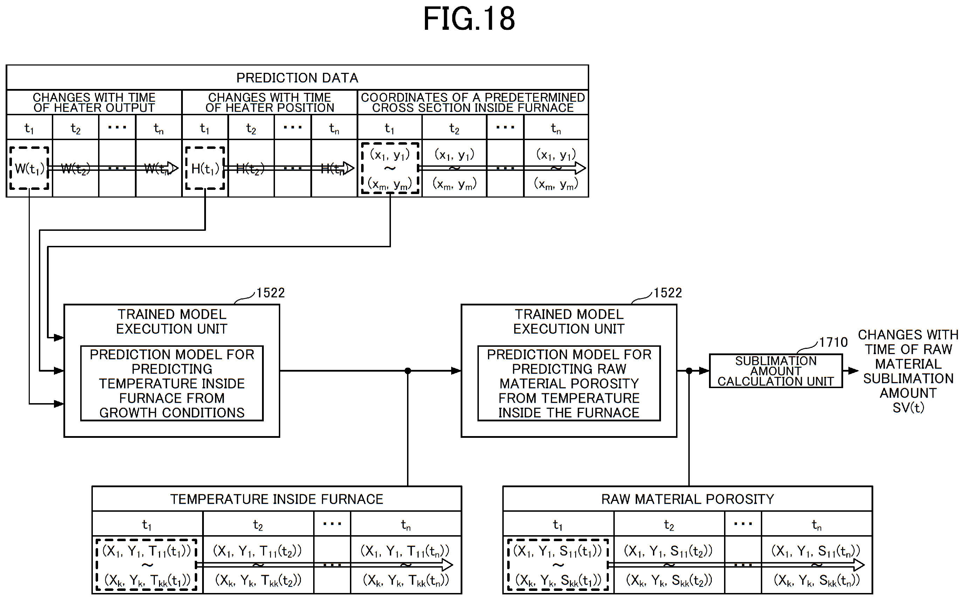

Nest, a specific example of prediction processing using the second and third trained model will be described. FIG. 18 is a second drawing illustrating a specific example of the prediction processing by the prediction unit.

As shown in FIG. 18, the trained model execution unit 1522 reads a "prediction model for predicting temperature inside the furnace from the material conditions" as the second trained model, and sequentially inputs prediction data:
· changes with time of heater output: W(t);
· changes with time of heater position: H(t); and
· coordinates at a specific cross-section in the furnace: (x₁, y₁) to (xₘ, yₘ)
from time t₁. Thus, the "prediction model for predicting temperature inside the furnace from the material conditions", which is an example of the second trained model, sequentially outputs
· temperature inside the furnace at each coordinate at each time: (X₁, Y₁, T₁₁(t)) to (Xₖ, Yₖ, Tₖₖ(t)) from time t₁.

As shown in FIG. 18, the trained model execution unit 1522 reads the "prediction model for predicting raw material porosity from temperature inside the furnace" as the third trained model, and sequentially inputs
· furnace temperature at each coordinate at each time: (X₁, Y₁, T₁₁(t)) to (Xₖ, Yₖ, Tₖₖ(t))
from time t1. Thus, the "prediction model for predicting raw material porosity from temperature inside the furnace", which is an example of the third trained model, sequentially outputs
· raw material porosity at each coordinate at each time: (X₁, Y₁, S₁₁(t)) to (Xₖ, Yₖ, Sₖₖ(t))
output from time t₁.

The sublimation amount calculation unit 1710 calculates the changes with time SV(t) of the raw material sublimation amount by summing the raw material porosity at each coordinate at each time, sequentially output from the "prediction model for predicting the raw material porosity from the furnace temperature", which is an example of the third trained model, for all coordinates.

### (3) PREDICTION PROCESSING USING FOURTH TRAINED MODEL

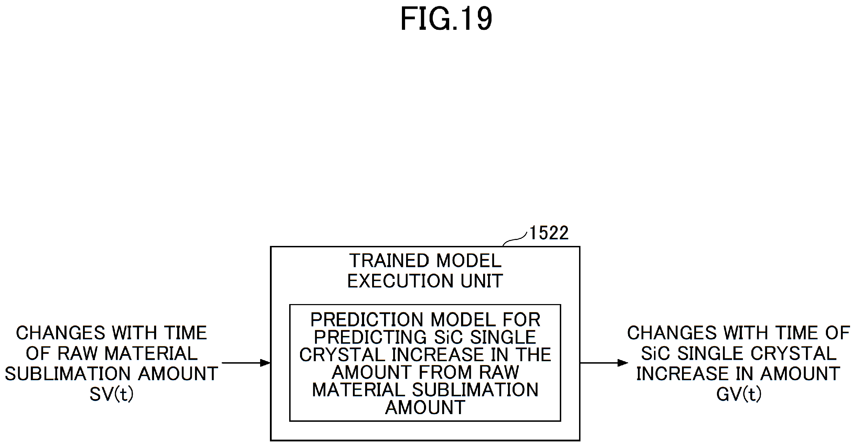

First, a specific example of prediction processing using the fourth trained model will be described. FIG. 19 is a third drawing illustrating a specific example of the prediction processing by the prediction unit.

As shown in FIG. 19, the trained model execution unit 1522 reads a "prediction model for predicting SiC single crystal increase in the amount from raw material sublimation amount" as the fourth trained model, and sequentially inputs prediction data:
· changes with time of raw material sublimation amount: SV(t)
from time t₁. Thus, the "prediction model for predicting SiC single crystal increase in the amount from raw material sublimation amount", which is an example of the fourth trained model, sequentially outputs
· changes with time of SiC single crystal increase in the amount: GV(t)
from time t₁.

### <DESCRIPTION OF DESIGN ASSISTANCE SCREEN>

Next, the design assistance screen displayed by the display unit 131 will be described.

### (1) FIRST DESCRIPTION OF DESIGN ASSISTANCE SCREEN

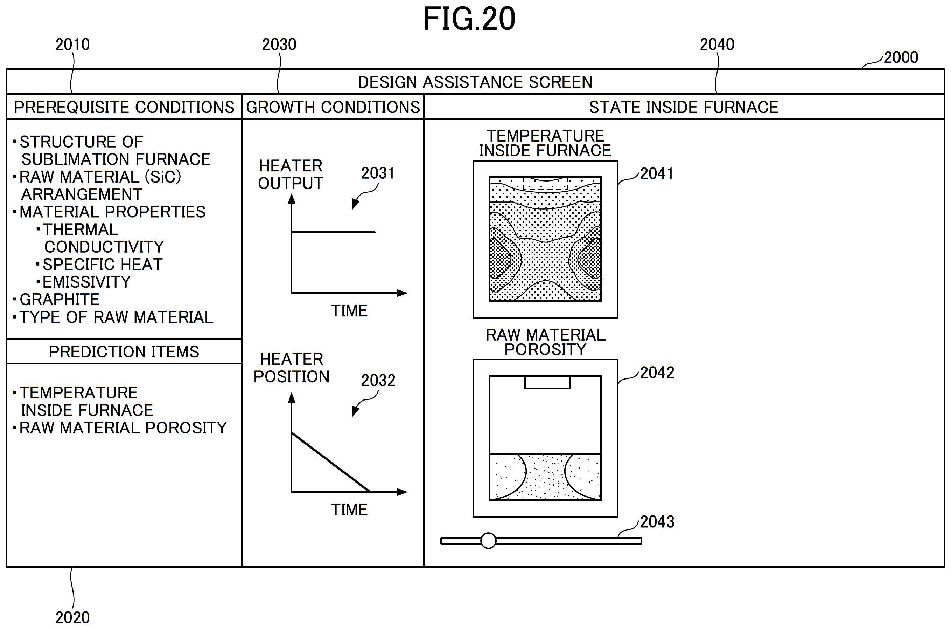

FIG. 20 is a first drawing illustrating an example of a design assistance screen. As shown in FIG. 20, the design assistance screen 2000 includes a prerequisite condition input region 2010, a prediction item input region 2020, a growth condition input region 2030, and a furnace state display region 2040.

As shown in FIG. 20, the prerequisite condition input region 2010 is provided with input fields for inputting prerequisite conditions. An example of FIG. 20 illustrates:
- data for specifying the structure of the sublimation furnace;
- data for specifying the arrangement of SiC powder as a raw material;
- thermal conductivity, specific heat, and emissivity, which are the material properties of each component of the sublimation furnace;
- data indicating the type of graphite included in the graphite crucible; and
- type of SiC powder as a raw material.

As shown in FIG. 20, the prediction item input region 2020 is provided with input fields for inputting prediction items for predicting information indicating the state inside the furnace using any of the first to fourth trained models. The example shown in FIG. 20 illustrates a state in which:
- temperature inside the furnace; and
- raw material porosity
are input.

As shown in FIG. 20, the growth condition input region 2030 is provided with input fields for inputting growth conditions for predicting information indicating the state inside the furnace using any of the first to fourth trained models. The example shown in FIG. 20 illustrates a state in which:
- changes with time of the heater output; and
- changes with time of the heater position
are input. As shown in FIG. 20, in the first embodiment, the changes with time of the heater output and the changes with time of the heater position are input using graphs 2031 and 2032.

As shown in FIG. 20, the furnace state display region 2040 displays prediction results when the "furnace temperature" and "raw material porosity", which are the prediction items input to the prediction item input region 2020, are predicted using:
- second trained model; and
- third trained model.
As shown by reference numerals 2041 and 2042, distribution of the temperature in the furnace and the raw material porosity in a specific section of the furnace at each time is displayed. The user 140 can visually confirm the temperature in the furnace and the raw material porosity at any time by using a slider bar 2043.

### (2) SECOND DESCRIPTION OF DESIGN ASSISTANCE SCREEN

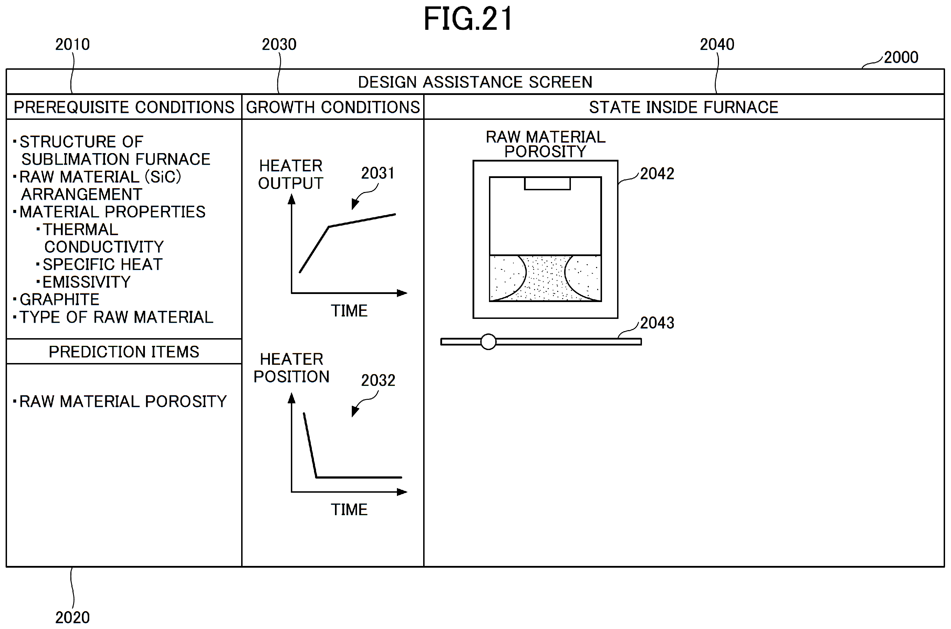

FIG. 21 is a second drawing illustrating the example of the design assistance screen. The difference from FIG. 20 is that only the raw material porosity is input to the prediction item input region 2020. Therefore, in the case of the example of FIG. 21, the furnace state display region 2040 displays the prediction result when the "raw material porosity" is predicted using
· the first trained model.

### (3) THIRD DESCRIPTION OF DESIGN ASSISTANCE SCREEN

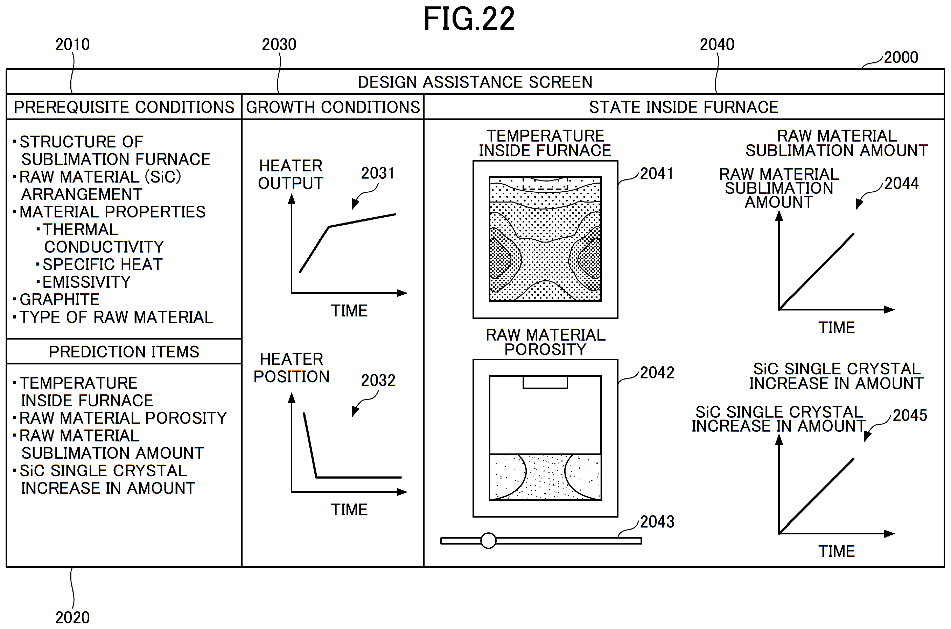

FIG. 22 is a third drawing illustrating the example of the design assistance screen. The difference from FIG. 20 is that the furnace temperature, raw material porosity, raw material sublimation amount, and SiC single crystal increase in the amount are input to the prediction item input region 2020. Therefore, in the case of the example of FIG. 22, the furnace state display region 2040 displays the prediction result of "furnace temperature" predicted using
· the second trained model,
the prediction result of "raw material porosity" and "raw material sublimation amount" (see graph 2044) predicted using
· the third trained model, and
the prediction result of "SiC single crystal increase in the amount" (see graph 2045) predicted using
• the fourth trained model.

### (4) FOURTH DESCRIPTION OF DESIGN ASSISTANCE SCREEN

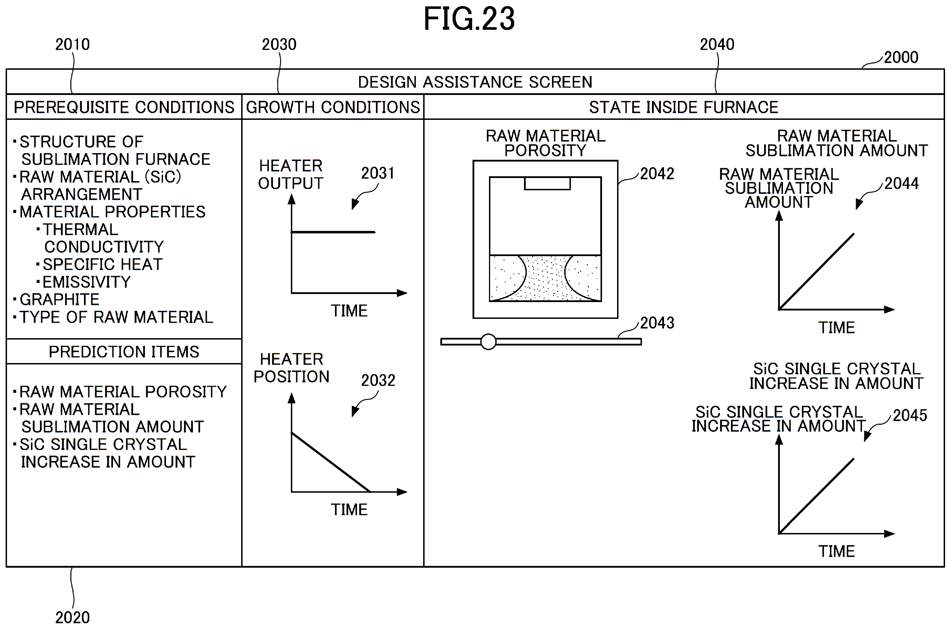

FIG. 23 is a fourth drawing illustrating the example of the design assistance screen. The difference from FIG. 20 is that the raw material porosity, raw material sublimation amount, and SiC single crystal increase in the amount are input to the prediction item input region 2020. Therefore, in the case of the example of FIG. 23, the furnace state display region 2040 displays the prediction results of the "raw material porosity" and "raw material sublimation amount" (see graph 2044) predicted using
- the first trained model, and
the prediction result of "SiC single crystal increase in the amount" (see graph 2045) predicted using
• the fourth trained model.

### FLOW OF DESIGN ASSISTANCE PROCESSING

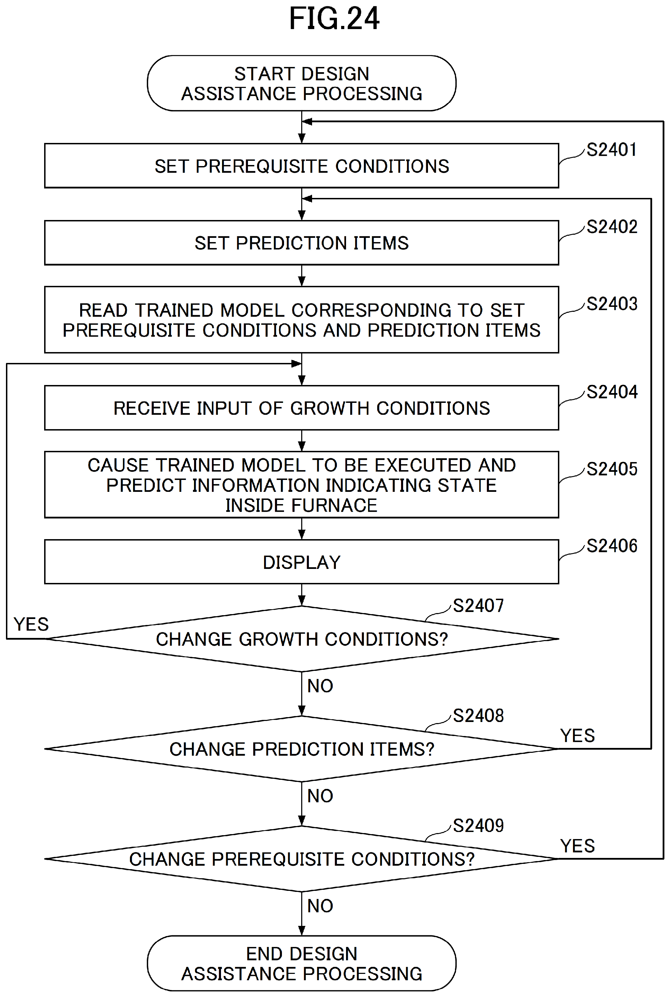

Next, a flow of design assistance processing by the design assistance apparatus 130 will be described. FIG. 24 is a first flowchart illustrating a flow of design assistance processing.

In a step S2401, the design assistance apparatus 130 sets prerequisite conditions.

In a step S2402, the design assistance apparatus 130 sets prediction items.

In a step S2403, the design assistance apparatus 130 reads the trained model corresponding to the set prerequisite conditions and prediction items.

In a step S2404, the design assistance apparatus 130 receives input of the growth conditions.

In a step S2405, the design assistance apparatus 130 causes the trained model read in the step S2403 to be executed with the growth conditions received in the step S2404 as input data. Thus, the design assistance apparatus 130 predicts information indicating the state inside the furnace for the set prediction items.

In a step S2406, the design assistance apparatus 130 displays the predicted information indicating the state inside the furnace for the prediction items as prediction results.

In a step S2407, the design assistance apparatus 130 determines whether or not there is an instruction to change the growth conditions. If it is determined in the step S2407 that there is an instruction to change the growth conditions (YES in the step S2407), the processing returns to the step S2404.

Conversely, if it is determined in the step S2407 that there is no instruction to change the growth conditions (NO in the step S2407), the processing proceeds to a step S2408.

In the step S2408, the design assistance apparatus 130 determines whether or not there is an instruction to change the prediction items. If it is determined in the step S2408 that there is an instruction to change the prediction items (YES in the step S2408), the processing returns to the step S2402.

Conversely, if it is determined in the step S2408 that there is no instruction to change the prediction items (NO in the step S2408), the processing proceeds to a step S2409.

In the step S2409, the design assistance apparatus 130 determines whether or not there is an instruction to change the prerequisite conditions. If it is determined in the step S2409 that there is an instruction to change the prerequisite conditions (YES in the step S2409), the processing returns to the step S2401.

Conversely, if it is determined in the step S2409 that there are no instructions to change the prerequisite conditions (NO in the step S2409), the design assistance processing ends.

### <SUMMARY>

As is clear from the above description, the design assistance system 100 according to the first embodiment:
- performs simulation using a simulation apparatus 110 reproducing a growth apparatus for growing an SiC single crystal by a sublimation method to generate training data for various combinations of input data and ground truth;
- generates respective trained models by learning, based on the generated training data, the respective relationships between the input data and the ground truth; and
- predicts information indicating a state inside the furnace from growth conditions by using one or more trained models among the generated trained models.

Thus, according to the first embodiment, it is possible to predict the information indicating the state inside the furnace at a low computational cost, and it is possible to assist in smoothly designing the growth conditions in the process for growing the SiC single crystal by the sublimation method.

### [SECOND EMBODIMENT]

In the first embodiment described above, when the input of the growth conditions is received on the design assistance screen, information indicating the state inside the furnace is predicted and the predicted information indicating the state inside the furnace is displayed.

Additionally, in the second embodiment, when prediction results are displayed by predicting the information indicating the state inside the furnace on the design assistance screen and a request for changing the prediction results is input by the user, the growth conditions which are the predicted result after the change are searched. Thus, according to the second embodiment, the growth conditions for achieving the prediction results requested by the user can be proposed to the user. Hereinafter, the second embodiment will be described mainly with respect to differences from the first embodiment.

### <FUNCTIONAL CONFIGURATION OF DESIGN ASSISTANCE APPARATUS>

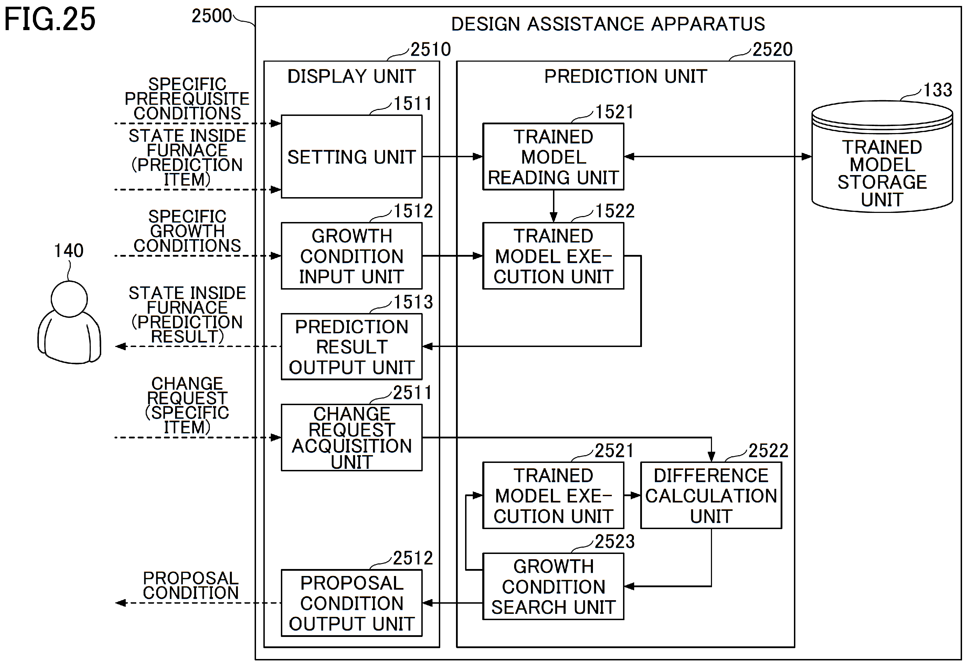

First, the functional configuration of the design assistance apparatus according to the second embodiment will be described. FIG. 25 is a second drawing illustrating an example of a functional configuration of a design assistance apparatus. As shown in FIG. 25, the design assistance apparatus 2500 according to the second embodiment functions as a display unit 2510 and a prediction unit 2520. The display unit 2510 includes a setting unit 1511, a growth condition input unit 1512, a prediction result output unit 1513, a change request acquisition unit 2511, and a proposal condition output unit 2512. The prediction unit 2520 includes a trained model reading unit 1521, a trained model execution unit 1522, a trained model execution unit 2521, a difference calculation unit 2522, and a growth condition search unit 2523.

Of the components included in the display unit 2510, description of the components from the setting unit 1511 to the prediction result output unit 1513 is omitted here because they have already been described with reference to FIG. 15 in the first embodiment.

In response to the information indicating the state inside the furnace being displayed to the user 140 using the design assistance screen by the prediction result output unit 1513, the change request acquisition unit 2511 receives a change request when it is input by the user 140. The change request refers to a request to change a part of the information indicating the state inside the furnace. The change request acquisition unit 2511 provides the difference calculation unit 2522 with the changed output data based on the change request.

In response to the changed information indicating the state inside the furnace being provided to the difference calculation unit 2522 by the change request acquisition unit 2511, the proposal condition output unit 2512 obtains growth conditions (referred to as proposal conditions) proposed by the growth condition search unit 2523. The proposal condition output unit 2512 displays the obtained proposal conditions to the user 140.

The trained model execution unit 2521, which is similar to the trained model execution unit 1522, executes the trained model by inputting the growth conditions provided by the growth condition search unit 2523 and predicts the information indicating the state inside the furnace.

The difference calculation unit 2522 calculates a difference between the information indicating the state inside the furnace predicted by the trained model execution unit 2521 and the changed information indicating the state inside the furnace provided by the change request acquisition unit 2511. The difference calculation unit 2522 provides the growth condition search unit 2523 with the calculated difference.

The growth condition search unit 2523 comprehensively generates growth conditions under a specific constraint range. The growth condition search unit 2523 provides a trained model execution unit 2521 with the comprehensively generated growth conditions. The growth condition search unit 2523 obtains differences corresponding to respective comprehensively generated growth conditions from a difference calculation unit 2522. The growth condition search unit 2523 searches for growth conditions that minimize the obtained difference.

The growth condition search unit 2523 provides a proposal condition output unit 2512 with the searched growth conditions as proposal conditions.

### <DESCRIPTION OF DESIGN ASSISTANCE SCREEN>

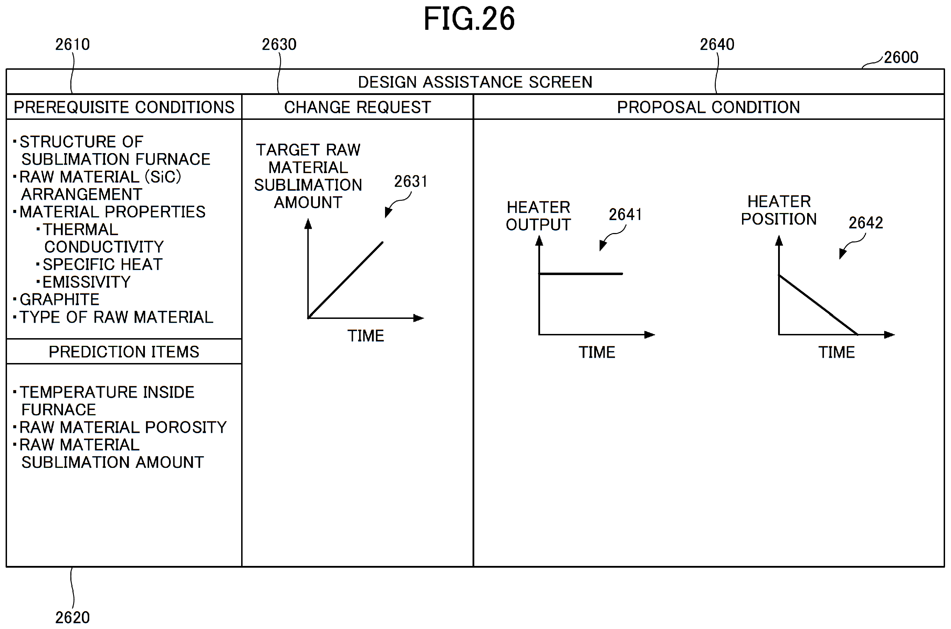

Next, a design assistance screen displayed by the display unit 2510 will be described. FIG. 26 is a second drawing illustrating the example of the design assistance screen.

As shown in FIG. 26, the design assistance screen 2600 includes a prerequisite condition input region 2610, a prediction item input region 2620, a change request input region 2630, and a proposal condition display region 2640.

Of these, the prerequisite condition input region 2610 and the prediction item input region 2620 are the same as the prerequisite condition input region 2010 and the prediction item input region 2020 described with reference to FIG. 20, and therefore, the description thereof is omitted here.

In the change request input region 2630, a change request for changing a part of information indicating a state inside the furnace is input. In the example shown in FIG. 26, "raw material sublimation amount" is selected as information indicating a state inside the furnace, and a part of the changes with time of the raw material sublimation amount is changed. As shown in FIG. 26, the changes with time of the raw material sublimation amount are displayed as a graph 2631 in the change request input region 2630, and the user 140 changes a part of the changes with time of the raw material sublimation amount by changing a part of the graph 2631.

As shown in FIG. 26, when a change request is input to the change request input region 2630, proposal conditions are displayed in the proposal condition display region 2640. The example shown in FIG. 26 shows a state in which a graph 2641 illustrating changes with time of a heater output and a graph 2642 illustrating changes with time of a heater position are displayed as the proposal condition.

### <FLOW OF DESIGN ASSISTANCE PROCESSING>

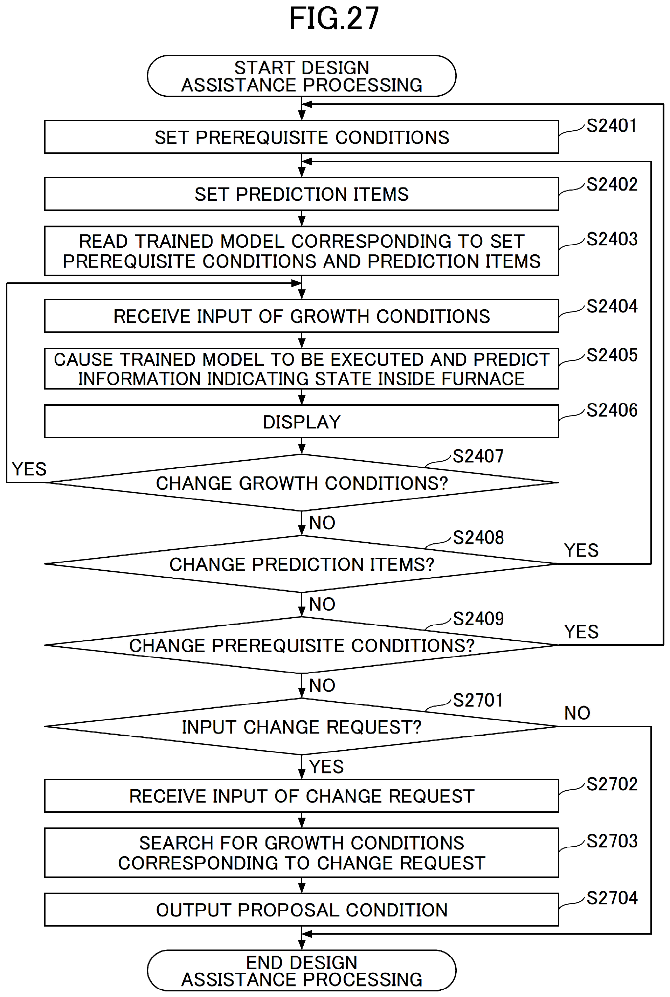

Next, a flow of design assistance processing by the design assistance apparatus 2500 will be described. FIG. 27 is a second flowchart illustrating the flow of the design assistance processing. In the second flowchart shown in FIG. 24, each step from the step S2401 to the step S2409 is the same as each step from the step S2401 to the step S2409 in the first flowchart shown in FIG. 24, and therefore, description thereof is omitted here.

In a step S2701, the design assistance apparatus 2500 determines whether or not a change request for changing part of the information indicating the state inside the furnace has been input. If it is determined in the step S2701 that no change request has been input (NO in the step S2701), the design assistance processing is terminated. Conversely, if it is determined in the step S2701 that the change request has been input (if YES in the step S2701), the processing proceeds to a step S2702.

In the step S2702, the design assistance apparatus 2500 receives input of the change request by the user 140 using the design assistance screen 2600.

In a step S2703, the design assistance apparatus 2500 comprehensively generates growth conditions under a specific restriction range. The design assistance apparatus 2500 searches for growth conditions that minimize the difference with the changed information indicating the state inside the furnace changed by the change request from among the predicted results when the state inside the furnace is predicted based on the growth conditions.

In a step S2704, the design assistance apparatus 2500 displays the growth conditions that minimize the difference searched in the step S2702 as a proposed condition to the user 140 using the design assistance screen 2600.

### SUMMARY

As is clear from the above description, the design assistance system 100 according to the second embodiment:
- accepts a change request from the user 140 for a part of the information indicating the state inside the furnace displayed on the design assistance screen;
- searches the growth conditions so that the difference between the predicted information indicating the state inside the furnace and the changed information indicating the state inside the furnace is minimized; and
- displays the searched growth conditions on the design assistance screen as the proposed conditions.

As described above, according to the design assistance system 100 according to the second embodiment, the growth conditions for changing the information indicating the state inside the furnace to desired information can be searched, so that the convenience of the user when designing the growth conditions can be improved.

### [THIRD EMBODIMENT]

Although the method of using the proposed conditions output by the design assistance apparatus 2500 is not described in the second embodiment, the proposed conditions output by the design assistance apparatus 2500 may be reflected in the growth apparatus 10. Hereinafter, the third embodiment will be described mainly with respect to differences from the above-mentioned respective embodiments.

### <SYSTEM CONFIGURATION OF DESIGN ASSISTANCE SYSTEM>

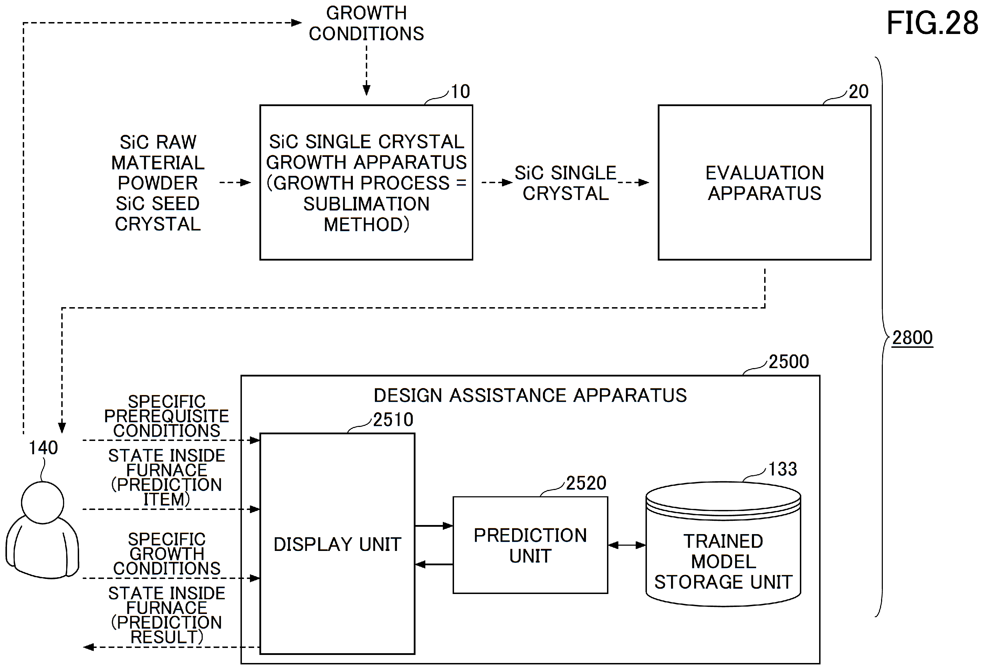

First, the system configuration of the design assistance system according to the third embodiment will be described. FIG. 28 is a second drawing illustrating an example of the system configuration of the design assistance system.

As shown in FIG. 28, the design assistance system 2800 according to the third embodiment includes a growth apparatus 10, an evaluation apparatus 20, and a design assistance apparatus 2500.

Of these, the growth apparatus 10 and the design assistance apparatus 2500 have already been described in the first embodiment or the second embodiment and will not be described here.

The evaluation apparatus 20 is an evaluation apparatus for evaluating the SiC single crystal grown by the growth apparatus 10. The evaluation result evaluated by the evaluation apparatus 20 is provided to the user 140.

The user 140 examines how the state inside the furnace should be changed based on the evaluation result provided from the evaluation apparatus 20. The user 140 inputs the examined change request to the design assistance apparatus 2500 using the design assistance screen 2600. When inputting the change request, it is assumed that information indicating the state inside the furnace predicted based on the present growth conditions set in the growth apparatus 10 is displayed on the design assistance screen 2600.

Since the proposed conditions are displayed on the design assistance screen 2600 of the design assistance apparatus 2500 by inputting the change request by the user 140, the user 140 reflects the displayed proposed conditions to the growth conditions in the growth apparatus 10.

### <SUMMARY>

As is clear from the above description:
- the design assistance system 2800 according to the third embodiment includes the growth apparatus 10, the evaluation apparatus 20, and the design assistance apparatus 2500; and
- the change request corresponding to the evaluation result by the evaluation apparatus 20 is input to the design assistance apparatus 2500, and the proposed conditions output by the design assistance apparatus 2500 are reflected in the growth conditions in the growth apparatus 10.

As described above, according to the design assistance system 2800 according to the third embodiment, since
- the growth conditions can be designed according to events occurring at a growth site,
- the user's convenience in designing the growth conditions can be improved.

That is, according to the third embodiment, it is possible to provide the design assistance system 2800 that assists in designing the growth conditions in the process for growing the SiC single crystal by the sublimation method.

### [OTHER EMBODIMENTS]

In the first embodiment, the first training data 610A to the fourth training data 910A are exemplified as training data, but the training data is not limited to the above. For example, input data of training data may include:
- changes with time of heater output: W(t); and
- changes with time of heater position: H(t), and ground truth of the training data may include
- raw material sublimation amount at each time: SV(t).
Alternatively, the input data may include:
- changes with time of heater output: W(t); and
- changes with time of heater position: H(t), and the ground truth may include
- SiC single crystal increase in the amount at each time: GV(t).
Note that in the case of the first embodiment, any of the training data may be roughly classified into:
- first training data:
   input data = growth conditions; and
   ground truth = first-item data, and
- second training data:
   input data = first-item data; and
   ground truth = second-item data.
Namely, the raw material sublimation amount and the SiC single crystal increase in the amount are examples of the first-item data indicating the state inside the furnace at each time. Note that input data of the first training data may include prerequisite conditions in addition to growth conditions.

Similarly, in the first embodiment, the first model 550_1 to the fourth model 550_4 are exemplified as models, but the models are not limited to these four types. For example, a model in which
- changes with time of heater output: W(t); and
- changes with time of heater position: H(t)
are input as input data to output
- raw material sublimation amount at each time: SV(t) may be included. Alternatively, a model in which
- changes with time of heater output: W(t); and
- changes with time of heater position: H(t) are input as input data to output
- SiC single crystal increase in the amount at each time: GV(t)
may be included. Note that in the case of the first embodiment, any of the training data may be roughly classified into:
- a first model to be trained using the first training data; and
- a second model to be trained using the second training data.

Similarly, in the first embodiment, four trained models are exemplified as trained models to be executed by the trained model execution unit 1522, but the models executed by the trained model execution unit 1522 are not limited to four types. For example, a prediction model in which
- changes with time of heater output: W(t); and
- changes with time of heater position: H(t)
are input as input data to predict
- raw material sublimation amount at each time: SV(t) may be included. Alternatively, a prediction model in which
- changes with time of heater output: W(t); and
- changes with time of heater position: H(t)
are input as input data to predict
- SiC single crystal increase in the amount at each time: GV(t)
may be included. Note that in the case of the first embodiment, any of the training data may be roughly classified into:
- a first trained model trained using the first training data; and
- a second trained model trained using the second training data.

In the first embodiment, when the furnace temperature and the raw material porosity are displayed as information indicating the state of the furnace in the design assistance screen 2000, an image of a color (predetermined color) corresponding to the data value of each coordinate is shown. However, the relationship between the data value and the color (pixel value) may be appropriately changed by the user 140.

Specifically, a range of the data value may be set for each prediction item, and the pixel value of each coordinate may be calculated by color converting the data value of each coordinate according to the range.

In the first embodiment described above, the simulation apparatus 110, the training apparatus 120, and the design assistance apparatus 130 are configured as separate devices in the design assistance system 100. However, in the design assistance system 100, the simulation apparatus 110, the training apparatus 120, and the design assistance apparatus 130 may be configured as seamless apparatuses. Alternatively, any two apparatuses may be configured as seamless apparatuses.

In the first embodiment described above, the furnace temperature is used as the second training data or the third training data. However, instead of the furnace temperature, a gas concentration in the furnace, a gas flow rate inside the furnace, or the like may be used.

In the first embodiment described above, the respective functional configurations of the simulation apparatus 110, the training apparatus 120, and the design assistance apparatus 130 are examples, and a part of the function of any of the apparatuses may be achieved in other apparatuses.

In the second embodiment described above, the case where a part of the changes with time of the raw material sublimation amount is changed is described as a change request. However, the change request is not limited to changing a part of the changes with time of the raw material sublimation amount. For example, the temperature of a part of positions in the furnace in a specific time range may be changed. Alternatively, the raw material porosity of a part of positions in the furnace in a specific time range may be changed.

In the third embodiment, when the user 140 inputs the change request, the current growth conditions set in the growth apparatus 10 are input to the design assistance screen 2600 by the user 140. However, the current growth conditions input by the design assistance screen 2600 may be automatically input by communication with the growth apparatus 10. Thus, information indicating the current state inside the furnace of the growth apparatus 10 is always displayed on the design assistance screen 2600.

In the third embodiment, the user 140 examines how the state inside the furnace should be changed based on the evaluation result provided from the evaluation apparatus 20, and then inputs the change request to the design assistance apparatus 2500 using the design assistance screen 2600. However, an appropriate change request may be automatically made based on the evaluation result.

Further, the present invention is not limited to these embodiments, and various variations and modifications may be made without departing from the scope of the present invention.

The present application is based on and claims priority to Japanese patent application no. 2023-185442 filed on October 30, 2023, with the Japan Patent Office, the entire contents of which are hereby incorporated by reference.

### REFERENCE SIGNS LIST

- 10: : growth apparatus
- 20: : evaluation apparatus
- 100: : design assistance system
- 110: : simulation apparatus
- 120: : training apparatus
- 121: : training data generation unit
- 122: : training unit
- 130: : design assistance apparatus
- 131: : display unit
- 132: : prediction unit
- 210: : graphite crucible
- 220: : seed crystal
- 231: : SiC powder
- 232: : sublimed gas
- 233: : SiC single crystal
- 240: : heater
- 550_1: : first model
- 550_2: : second model
- 550_3: : third model
- 550_4: : fourth model
- 1110: : filter processing unit
- 1210: : filter processing unit
- 1511: : setting unit
- 1512: : growth condition input unit
- 1513: : prediction result output unit
- 1521: : trained model reading unit
- 1522: : trained model execution unit
- 1710: : sublimation amount calculation unit
- 2000: : design assistance screen
- 2500: : design assistance apparatus
- 2510: : display unit
- 2520: : prediction unit
- 2511: : change request acquisition unit
- 2512: : proposal condition output unit
- 2521: : trained model execution unit
- 2522: : difference calculation unit
- 2523: : growth condition search unit
- 2600: : design assistance screen
- 2800: : design assistance system

## Claims

1. A design assistance system for assisting in designing growth conditions applied to a process for growing an SiC single crystal using a sublimation method, comprising:
a first storage unit configured to store a first trained model that has been trained using first training data including:
growth conditions at each time point input into a simulation apparatus that reproduces the process; and
first-item data indicating a state inside a furnace at each time point, the first-item data being simulated based on the growth conditions input at each time point;
a prediction unit configured to predict first-item data indicating a state inside the furnace at each time point by inputting growth conditions for prediction at each time point into the first trained model; and
a display unit configured to display the predicted first-item data.

2. The design assistance system according to claim 1, wherein:
the first storage unit is configured to store the first trained model that has been trained using the first training data including:
the growth conditions at each time point and coordinates of each position inside the furnace; and
the first-item data indicating the state inside the furnace at each time point at each position inside the furnace, the first-item data being simulated based on the growth conditions at each time point;
the prediction unit is configured to predict first-item data indicating a state inside the furnace at each time point at each position inside the furnace by inputting growth conditions for prediction at each time point and coordinates of each position inside the furnace into the first trained model; and
the display unit is configured to display the predicted first-item data.

3. The design assistance system according to claim 2, wherein the first trained model is generated by updating a parameter of a first model so as to minimize a calculation result at a loss function capable of calculating a difference between:
first-item data output from the first model when the growth conditions at each time point and coordinates of each position inside the furnace included in the first training data are input into the first model; and
first-item data corresponding to the growth conditions at each time point and coordinates of each position inside the furnace included in the first training data.

4. The design assistance system according to claim 2, wherein the first trained model is generated by updating a parameter of a first model so as to minimize a calculation result at a loss function capable of calculating a difference between:
data obtained by applying an image processing filter to first-item data output from the first model when the growth conditions at each time point and coordinates of each position inside the furnace included in the first training data are input into the first model; and
data obtained by applying the image processing filter to first-item data corresponding to the growth conditions at each time point and coordinates of each position inside the furnace included in the first training data.

5. The design assistance system according to claim 2, wherein the first trained model is generated by updating a parameter of a first model so as to minimize a calculation result at a loss function capable of performing weighted addition of:
a difference between:
first-item data output from the first model; and
first-item data corresponding to the growth conditions at each time point and coordinates of each position inside the furnace included in the first training data; and
a difference between:
data obtained by applying an image processing filter to the first-item data output from the first model; and
data obtained by applying the image processing filter to the first-item data corresponding to the growth conditions at each time point and coordinates of each position inside the furnace included in the first training data.

6. The design assistance system according to any one of claims 2 to 5, wherein the first-item data indicating the state inside the furnace at each time point at each position inside the furnace includes any one of:
temperature at each time point at each position inside the furnace;
a gas concentration at each time point at each position inside the furnace;
a gas flow rate at each time point at each position inside the furnace; and
raw material porosity at each time point at each position inside the furnace.

7. The design assistance system according to claim 1, wherein the first-item data indicating the state inside the furnace at each time point includes any one of:
a raw material sublimation amount at each time point; and
SiC single crystal increase in an amount at each time point.

8. The design assistance system according to any one of claims 2 to 6, comprising a second storage unit configured to store:
the first-item data indicating the state inside the furnace at each time point at each position inside the furnace, the first-item data being simulated based on the growth conditions input into the simulation apparatus that reproduces the process at each time point; and
a second trained model that has been trained using second training data including second-item data corresponding to the first-item data, wherein:
the prediction unit is configured to:
input the first-item data indicating the state inside the furnace at each time point at each position inside the furnace, predicted by inputting the growth conditions at each time point and coordinates of each position inside the furnace into the first trained model, into the second trained model; and
predict the second-item data indicating the state inside the furnace at each time point at each position inside the furnace; and
the display unit is configured to display the predicted second-item data.

9. The design assistance system according to claim 8, wherein the second trained model is generated by updating a parameter of a second model so as to minimize a calculation result at a loss function capable of calculating a difference between:
second-item data output from the second model when the first-item data included in the second training data is input into the second model; and
second-item data corresponding to the input first-item data included in the second training data.

10. The design assistance system according to claim 9, wherein a combination of the first-item data and the second-item data included in the second training data includes any one of:
a combination of temperature at each time point at each position inside the furnace and raw material porosity at each time point at each position inside the furnace; and
a combination of raw material sublimation amount at each time point at each position inside the furnace and SiC single crystal increase in an amount at each time point at each position inside the furnace.

11. The design assistance system according to claim 10, wherein the raw material sublimation amount at each time point is calculated based on the raw material porosity at each time point at each position inside the furnace.

12. The design assistance system according to claim 1 or 2, further comprising a search unit configured to search for the growth conditions for prediction at each time for predicting the first-item data after change, when a change in a part of the first-item data predicted by the prediction unit is received, wherein the display unit is configured to display the growth conditions for prediction at each time that has been searched for.

13. The design assistance system according to claim 8, further comprising a search unit configured to search for the growth conditions for prediction at each time for predicting the second-item data after change, when a change in a part of the second-item data predicted by the prediction unit is received, wherein the display unit is configured to display the growth conditions for prediction at each time that has been searched for.

14. The design assistance system according to claim 1 or 2, wherein the first trained model is a recurrent neural network.

15. The design assistance system according to claim 8, wherein the second trained model is a recurrent neural network.

16. The design assistance system according to claim 14 or 15, wherein the recurrent neural network is any one of RNN, LSTM, GRU, Seq2Seq, Bidirectional RNN, Seq2Seq with attention mechanism, and Transformer.

17. A design assistance method wherein a computer of a design assistance system for assisting in designing growth conditions applied to a process for growing an SiC single crystal using a sublimation method is configured to execute:
reading, from a first storage unit, a first trained model that has been trained using first training data including:
growth conditions at each time point input into a simulation apparatus that reproduces the process; and
first-item data indicating a state inside a furnace at each time point, the first-item data being simulated based on the growth conditions input at each time point;
predicting first-item data indicating a state inside the furnace at each time point by inputting growth conditions for prediction at each time point into the first trained model; and
displaying the predicted first-item data.

18. A design assistance program for causing a computer of a design assistance system for assisting in designing growth conditions applied to a process for growing an SiC single crystal using a sublimation method to execute:
reading, from a first storage unit, a first trained model that has been trained using first training data including:
growth conditions at each time point input into a simulation apparatus that reproduces the process; and
first-item data indicating a state inside a furnace at each time point, the first-item data being simulated based on the growth conditions input at each time point;
predicting first-item data indicating a state inside the furnace at each time point by inputting growth conditions for prediction at each time point into the first trained model; and
displaying the predicted first-item data.
